(19)

**Europäisches Patentamt**
**European Patent Office**
**Office européen des brevets**

(11) **EP 3 563 143 B1**

(12) **EUROPÄISCHE PATENTSCHRIFT**

(45) Veröffentlichungstag und Bekanntmachung des Hinweises auf die Patenterteilung:
**09.08.2023 Patentblatt 2023/32**

(21) Anmeldenummer: **17825532.9**

(22) Anmeldetag: **21.12.2017**

(51) Internationale Patentklassifikation (IPC):
**G01N 24/12** (2006.01)   **G01R 33/62** (2006.01)

(52) Gemeinsame Patentklassifikation (CPC):
**G01N 24/12; G01R 33/62**

(86) Internationale Anmeldenummer:
**PCT/EP2017/084229**

(87) Internationale Veröffentlichungsnummer:
**WO 2018/122124 (05.07.2018 Gazette 2018/27)**

(54) **VERFAHREN UND VORRICHTUNG ZUR HYPERPOLARISIERUNG EINER MATERIALPROBE**

METHOD AND DEVICE FOR THE HYPERPOLARIZATION OF A MATERIAL SAMPLE

PROCÉDÉ ET DISPOSITIF POUR L'HYPERPOLARISATION D'UN ÉCHANTILLON DE MATÉRIAU

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.12.2016 DE 102016015567**

(43) Veröffentlichungstag der Anmeldung:
**06.11.2019 Patentblatt 2019/45**

(73) Patentinhaber: **NVision Imaging Technologies GmbH**
**89081 Ulm (DE)**

(72) Erfinder:
• **SCHWARTZ, Ilai**
  **89073 Ulm (DE)**
• **PLENIO, Martin**
  **89073 Ulm (DE)**
• **CHEN, Qiong**
  **89231 Neu-Ulm (DE)**
• **WANG, Zhenyu**
  **89231 Neu-Ulm (DE)**

(74) Vertreter: **Huebner, Stefan Rolf et al**
**Postfach 101317**
**80087 München (DE)**

(56) Entgegenhaltungen:
**US-A1- 2015 064 113    US-A1- 2016 061 914**

• **EGOR A. NASIBULOV ET AL: "Theory of the Overhauser effect in the pulsed mode of EPR pumping: exploiting the advantages of coherent electron spin motion", PHYSICAL CHEMISTRY CHEMICAL PHYSICS., Bd. 14, Nr. 18, 2012, Seite 6459, XP055462190, GB ISSN: 1463-9076, DOI: 10.1039/c2cp23896a**
• **S. E. KORCHAK ET AL: "Low-Field, Time-Resolved Dynamic Nuclear Polarization with Field Cycling and High-Resolution NMR Detection", APPLIED MAGNETIC RESONANCE., Bd. 37, Nr. 1-4, 15. November 2009 (2009-11-15), Seiten 515-537, XP055462191, AU ISSN: 0937-9347, DOI: 10.1007/s00723-009-0060-0**
• **ALECCI M ET AL: "Low Field (10 mT) Pulsed Dynamic Nuclear Polarization", JOURNAL OF MAGNETIC RESONA, ACADEMIC PRESS, ORLANDO, FL, US, Bd. 138, Nr. 2, Juni 1999 (1999-06), Seiten 313-319, XP004407288, ISSN: 1090-7807, DOI: 10.1006/JMRE.1999.1721**
• **UN S. ET AL: "Pulsed dynamic nuclear polarization at 5T", CHEMICAL PHYSICS LETTERS, Bd. 189, Nr. 1, 24. Januar 1992 (1992-01-24), Seiten 54-59, XP055462196, Vienna DOI: 10.1016/0009-2614(92)85152-z**
• **K. Tateishi ET AL: "Room temperature hyperpolarization of nuclear spins in bulk", Proceedings of the National Academy of Sciences, vol. 111, no. 21, 12 May 2014 (2014-05-12), pages 7527-7530, XP055579389, US ISSN: 0027-8424, DOI: 10.1073/pnas.1315778111**

**Beschreibung**

Die Erfindung betrifft ein Verfahren und eine Vorrichtung zur Hyperpolarisierung einer Materialprobe, welche eine Anzahl von polarisierbaren Spinmomenten, insbesondere Kernspinmomenten, aufweist.

Befinden sich Spinmomente in einem Magnetfeld, so entstehen aufgrund magnetischer Wechselwirkungen Energieunterschiede zwischen verschiedenen Spinzuständen in Abhängigkeit der Orientierung oder Ausrichtung der Spinmomente zu dem Magnetfeld (Zeeman-Effekt). Diese Energieunterschiede bewirken in der Regel eine Polarisation, also Unterschiede zwischen den Besetzungszahlen der einzelnen Ausrichtungen. Unter Polarisierung oder Polarisation einer Anzahl von Spinmomenten ist nachfolgend insbesondere das Verhältnis aus der Differenz zwischen zwei besetzten Ausrichtungen, beispielsweise der Differenz zwischen der Anzahl der parallel (gleichgerichtet) und antiparallel (gegengerichtet) zu einem Magnetfeld orientierten Spinmomenten, und der Gesamtzahl von Spinmomenten zu verstehen.

Hyperpolarisierung, das bedeutet die Erzeugung einer geordneten Ausrichtung von (Kern-)Spinmomenten in einer Materialprobe weit über die thermische Gleichgewichtsverteilung (Gleichgewichtsmagnetisierung) hinaus, ist eines der bedeutendsten Verfahren zur Erhöhung der Auflösung und/oder Sensitivität bei einer Magnetresonanz-Analyse, insbesondere bei einer Kernspinresonanz-Analyse beziehungsweise NMR-Analyse (nuclear magnetic resonance) oder NMR-Untersuchung. Typischerweise tragen lediglich die entlang eines Magnetfeldes ausgerichteten Spinmomente (Nettoausrichtung, Spinpolarisation) zu einem Messsignal der Magnetresonanz-Analyse bei, sodass durch eine Erhöhung der Anzahl der ausgerichteten (polarisierten) Spinmomente eine wesentliche Verbesserung der Analyse bewirkt wird. Hyperpolarisation ermöglicht hierbei beispielsweise in biologischen und/oder medizinischen Anwendungen und Untersuchungen eine verbesserte Bestimmung der molekularen und/oder chemischen Zusammensetzung einer Materialprobe. Des Weiteren ermöglicht eine Hyperpolarisierung der Materialprobe verkürzte Messzeiten sowie den Einsatz niedriger magnetischer Feldstärken.

Zur Hyperpolarisierung einer Materialprobe ist es beispielsweise möglich, die zu analysierenden Kernspinmomente der Materialprobe in Wechselwirkung mit Elektronenspinmomenten zu bringen. Die Elektronenspinmomente weisen eine etwa tausendfach stärkere Wechselwirkungsenergie mit dem Magnetfeld auf, sodass sich im thermischen Gleichgewicht eine vergleichsweise höhere Anzahl an geordnet ausgerichteten beziehungsweise polarisierten Elektronenspinmomenten als für Kernspinmomente einstellt. Mit anderen Worten weisen die Elektronenspinmomente unter sonst identischen Bedingungen eine höhere Polarisierung beziehungsweise einen höheren Polarisierungsgrad (Polarisierungsanteil) als die Kernspinmomente auf.

Bei einer dynamischen Kernpolarisierung (dynamic nuclear polarization, DNP) wird die (thermische) Polarisierung der Elektronenspinmomente auf die damit wechselwirkenden Kernspinmomente übertragen. Dies bedeutet, dass die Kernspinmomente nach einem solchen Polarisationstransfer eine geordnete Ausrichtung entlang des Magnetfeldes aufweisen, die im Wesentlichen der Gleichgewichtsverteilung der Elektronenspinmomente vor der dynamischen Kernpolarisierung entspricht. Mit anderen Worten weisen die Kernspinmomente eine (Polarisations-)Verteilung auf, welche wesentlich größer ist, als die thermische Gleichgewichtsverteilung der Kernspinmomente.

Derartige DNP-Verfahren verwenden in der Regel eine kontinuierliche Hochfrequenz-Bestrahlung (continuous wave, CW) der Elektronenspinmomente, beispielsweise bei einem Polarisationstransfer mittels des Kern-Overhauser-Effekts (nuclear overhauser effect, NOE), oder eine gepulste Hochfrequenz-Bestrahlung der Elektronenspinmomente mittels einer (Puls-)Sequenz mit einer Anzahl von aufeinanderfolgenden Hochfrequenzpulsen. Gepulste DNP-Verfahren weisen hierbei im Vergleich zu CW-DNP-Verfahren typischerweise einen effektiveren Polarisationstransfer sowie reduzierte Anforderungen an die Stärke des Magnetfeldes auf. Ein typisches gepulstes DNP-Verfahren ist beispielsweise NOVEL (nuclear spin orientation via electron spin locking).

Gepulste DNP-Verfahren verwenden eine gepulste Hochfrequenz-Bestrahlung anstelle einer kontinuierlichen Hochfrequenz-Bestrahlung, jedoch erfolgt der Polarisationstransfer zwischen den Spinmomenten - wie in CW-DNP - weiterhin lediglich während des Zeitraums in welchem der Hochfrequenzpuls aktiv ist. Mit anderen Worten erfolgt der Polarisationstransfer in der Regel lediglich wenn die Elektronenspinmomente mit einem Hochfrequenzpuls bestrahlt werden.

Bei einem gepulsten DNP-Verfahren werden zum Zwecke eines effektiven Polarisationstransfers die Frequenz und die Amplitude der Hochfrequenzpulse typischerweise derart eingestellt, dass der Hochfrequenzpuls die sogenannte Hartmann-Hahn-Bedingung erfüllt. Dadurch weisen die Elektronenspinmomente und die Kernspinmomente in einem rotierenden Bezugsystem gleiche Energieabstände der jeweiligen (Spin-)Energieniveaus auf. In der Folge werden während der Bestrahlung mit dem Hochfrequenzpuls Flip-Flop-Prozesse der Elektronenspinmomente mit den Kernspinmomenten, und somit ein Polarisationstransfer oder Polarisationsaustausch zwischen diesen, ermöglicht. Für einen effektiven Polarisationstransfer ist es daher notwendig, dass die Hochfrequenz-Bestrahlung während des Hochfrequenzpulses möglichst genau die Hartmann-Hahn-Bedingung erfüllt. Dadurch entstehen vergleichsweise hohe Anforderungen an die Genauigkeit und Stabilität der Amplitude und/oder der Phasenlage sowie der Frequenz der Hochfrequenzpulse. Dies überträgt sich in der Folge nachteilig auf die Robustheit und die Kosten zur Durchführung eines derartigen Verfahrens.

Gepulste DNP-Verfahren weisen in der Regel eine vergleichsweise geringe Flexibilität auf. Insbesondere weist der durch das DNP-Verfahren realisierte Polarisationstransfer eine vergleichsweise geringe Robustheit oder Stabilität auf. Dies bedeutet, dass im Falle einer Abweichung der Frequenz (Detuning, Verstimmung) oder der Amplitude der Hochfrequenzpulse von der Hartmann-Hahn-Bedingung die Effektivität des Polarisationstransfers wesentlich oder vollständig reduziert wird. Derartige Abweichungen treten beispielsweise aufgrund von Inhomogenitäten des Magnetfeldes, Signalfluktuationen in Hochfrequenzbauteilen oder -generatoren, oder aufgrund physikalischer Einschränkungen wie der spektralen Linienbreite der Elektronenspinmomente auf. Insbesondere bei niedrigen Magnetfeldstärken und großen Abständen zwischen den Elektronenspinmomenten und Kernspinmomenten wird die spektrale Breite der Hartmann-Hahn-Bedingung vergleichsweise schmal, wodurch ein zuverlässiger Polarisationstransfer wesentlich erschwert wird.

In Taminiau, T. H., et. al, "Universal control and error correction in multi-qubits in registers in diamond" (Nature Nanotechnology 9.3, 2014, 171-176) wird eine gepulste Sequenz mit einer Anzahl von Hochfrequenzpulsen beschrieben, mittels welcher ein sogenanntes SWAP-Quantumgatter, zum kohärenten Vertauschen zweier Quantenzustände, zwischen einem Elektronenspinmoment und einem Kernspinmoment ausgeführt wird. Der zeitliche Abstand der Hochfrequenzpulse ist hierbei proportional zu einer Wechselwirkungsstärke zwischen dem Elektronenspinmoment und dem Kernspinmoment, und somit um Größenordnungen länger als eine Periode der Larmorpräzession der Kernspins. Unter bestimmten Bedingungen ist es hierbei möglich, mittels derartiger SWAP-Quantumgatter einen Polarisationstransfer zwischen den Spinmomenten zu bewirken.

Nachteiligerweise sind die bekannte Sequenz sowie die notwendigen Bedingungen zur Durchführung des SWAP-Quantumgatters nicht für eine Hyperpolarisierung eines Spinensembles, also einer Vielzahl von Spinmomenten, geeignet oder anwendbar. So ist beispielsweise eine genaue Bestimmung der Wechselwirkungsstärke zwischen dem ausgesuchten Kernspinmoment und dem Elektronenspinmoment zur Durchführung des SWAP-Quantumgatters für eine Hyperpolarisierung von Spinensembels nicht möglich, da hierbei eine Vielzahl von Elektronenspinmomenten jeweils mittels unbekannten Wechselwirkungsstärken an eine Vielzahl von umgebenden (zufällig angeordneten) Kernspinmomenten koppeln.

Auch im Falle eines theoretischen Szenarios, in welchem alle relevanten Wechselwirkungsstärken zwischen den Spinmomenten bekannt und konstant sind, und wobei eine Polarisationstransferzeit zum vollständigen Polarisationstransfer als das Inverse der jeweiligen Wechselwirkungsstärke (in Frequenzeinheiten) definiert ist, würden die bekannten Sequenzen aus Taminiau, T. H., et al. einen Polarisationstransfer erst nach mehr als der Hälfte der jeweiligen Polarisationstransferzeit bewirken. Dadurch wird die Effektivität des Polarisationstransfers der bekannten Sequenzen durch Störungen während kürzeren Zeitdauern, wie beispielsweise einer Dekohärenz des Elektronenspinmoments oder einer molekularen Bewegung (Diffusion) des Ziel-Kernspinmoments in flüssigen Materialproben, im Wesentlichen vollständig oder zumindest teilweise reduziert.

Somit ist es wünschenswert, dass durch Sequenzen, welche zur Hyperpolarisierung von Materialproben geeignet sein sollen, Polarisationstransferdynamiken bewirkt werden, welche im Wesentlichen unabhängig von der jeweiligen Wechselwirkungsstärke zwischen den Elektronen- und Kernspinmomenten sind. Des Weiteren ist es wünschenswert, dass diese Dynamiken auf einer Zeitskala bewirkt werden, welche signifikant schneller ist, als die durch die jeweilige Wechselwirkungsstärke bestimmte Polarisationstransferzeit. Vorzugsweise erfolgt der Polarisationstransfer hierbei auf einer Zeitskala vergleichbar mit der Larmorperiode der Kernspinmomente im Magnetfeld.

Aus der US 2015/0064113 A1 ist ein Verfahren zur Hyperpolarisierung eines Precursor-Moleküls als magnetisches Kontrastmittel für eine NMR-Analyse bekannt. Das Precursor-Molekül weist hierbei Spinmomente von zwei unterschiedlichen Kernspinsorten auf. Verfahrensgemäß wird das Precursor-Molekül hyperpolarisiert und anschließend mittels einer Sequenz von einem oder mehreren Radiofrequenzpulsen eine Polarisation von Spinmomenten der einen Kernspinsorte auf Spinmomente der anderen Kernspinsorte übertragen.

In der US 2016/0061914 A1 ist ein Verfahren zur Hyperpolarisierung von $^{13}$C-Kernspinmomenten in einem Diamanten beschrieben, bei welchem ein Elektronenspinmoment eines Farbzentrums optisch polarisiert wird, und anschließend dessen Polarisiation auf die $^{13}$C-Kernspinmomente übertragen wird. Der Polarisationstransfer wird hierbei mittels einer NOVEL-Sequenz bewirkt, in welcher der Polarisationstransfer zwischen den Spinmomenten lediglich während des Zeitraums des Hochfrequenzpulses aktiv ist.

Die US 2008/0231281 A1 offenbart eine Spulenvorrichtung für ein Kernspinresonanzsystem, mit einem Resonator, welcher einerseits zum Betrieb bei einer $^{13}$C-Larmorfrequenz und andererseits zum Betrieb bei einer $^{1}$H-Larmorfrequenz gestimmt ist. Im Betrieb der Spulenvorrichtung wird eine $^{1}$H-Kernspinpolarisation erzeugt und mittels des Kern-Overhauser-Effekts auf $^{13}$C-Kernspinmomente übertragen.

In Nasibulov, E. A., et al., "Theory of the Overhauser effect in the pulsed mode of EPR pumping: exploiting the advantages of coherent electron spin motion" (Phyical Cchemistry Chemical Physics., Bd. 14, Nr. 18, 2012, Seite 6459 ff.) wird ein theoretischer Ansatz zur Beschreibung der Oberhauser-artigen dynamischen Kernpolarisation im Falle eines gepulsten EPR-Pumpens mittels einer Serie von nanosekundenkurzen Pulen vorgestellt und ausgewertet. Das Verfahr4n nutzt eine kohärente Bewegung von Elektronenspins in einem Magnetfeld aus. Die Schrift verweist auf ein von Korchak, S. E., et al. in "Low-Field, Time-Resolved Dynamic Nuclear Polarization with Field Cycling and High-Resolution NMR Detection" (Applied Magnetic Resonance, Bd. 37, Nr. 1-4, 2009, Seite 515 ff.) näher beschriebenes Experiment, bei dem ein homogenes Magnetfeld zum Einsatz kommt. Ein ähnliches Verfahren ist aus Alecci, M., et al. "Low Field (10 mT) Pulsed Dynamic Nuclear Polarization" (Journal of Magnetic Resona, Bd. 138, Nr. 2, 1999, Seite 313 ff.) bekannt.

Der Erfindung liegt die Aufgabe zugrunde, ein besonders geeignetes Verfahren zur Hyperpolarisierung einer Materialprobe anzugeben. Der Erfindung liegt weiterhin die Aufgabe zugrunde, eine Vorrichtung zur Durchführung des Verfahrens anzugeben. Hinsichtlich des Verfahrens wird die Aufgabe mit den Merkmalen des Anspruchs 1 und hinsichtlich der Vorrichtung mit den Merkmalen des Anspruchs 11 erfindungsgemäß gelöst. Vorteilhafte Ausgestaltungen und Weiterbildungen sind Gegenstand derjeweiligen Unteransprüche.

Das erfindungsgemäße Verfahren ist zur Hyperpolarisierung einer Materialprobe, welche eine Anzahl van ersten Spinmomenten einer ersten Spinmomentsorte, nämlich Kernspinmomente, aufweist, geeignet und eingerichtet. Dies bedeutet, dass mittels des Verfahrens die Polarisierung beziehungsweise die geordnete Ausrichtung der ersten Spinmomente in der Materialprobe über die thermische Gleichgewichtsvertei lung (Gleichgewichtsmagnetisierung) hinaus erhöhbar ist.

Zu diesem Zwecke wird die Anzahl von ersten Spinmomenten in Wechselwirkung mit einem zweiten Spinmoment einer zweiten Spinmomentsorte, nämlich einem Elektronenspinmoment, gebracht. Die ersten und zweiten Spinmomente koppeln hierbei insbesondere lediglich schwach miteinander, dies bedeutet, dass die Stärke der Wechselwirkungen zwischen dem zweiten Spinmoment und den ersten Spinmoment vergleichsweise gering ist und insbesondere kleiner als die Larmorfrequenz der Spinmomente ist. Insbesondere sind die einzelnen Stärken der Wechselwirkungen zwischen den ersten und zweiten Spinmomenten im Wesentlichen unbekannt. Mit anderen Worten befindet sich das zweite Spinmoment vorzugsweise in einer Wechselwirkung mit einem Spinensemble von ersten Spinmomenten.

Anschließend werden die ersten und zweiten Spinmomente einem homogenen Magnetfeld ausgesetzt. Mit anderen Worten wird beispielsweise ein supraleitender Magnet zur Erzeugung des Magnetfeldes eingeschaltet. Das zweite Spinmoment wird hierbei entlang des Magnetfelds oder der Magnetfeldrichtung polarisiert. Ist das zweite Spinmoment beispielsweise Teil eines Moleküls oder eines Festkörpers, so ist es hierbei denkbar, dass aufgrund interner Felder die Ausrichtung oder Orientierung des zweiten Spinmoments im polarisierten Zustand von der Orientierung des (externen) Magnetfeldes abweicht. Wesentlich ist, dass durch die Einwirkung des Magnetfelds eine Nettoausrichtung oder -polarisierung des zweiten Spinmoments beziehungsweise dessen Spinzustände erzeugt wird, unabhängig von der tatsächlichen Orientierung im Raum.

Das zweite Spinmoment wird anschließend kohärent mittels einer (Puls-)Sequenz mit einer Anzahl von aufeinanderfolgenden und durch Zeitdauern (Pulsabstand, Repititionszeit, Evolutionszeit) zeitlich gegeneinander versetzten Hochfrequenzpulsen derart manipuliert, dass ein Polarisationstransfer von dem zweiten Spinmoment auf die ersten Spinmomente erfolgt. Dadurch ist ein besonders einfach zu implementierendes, gepulstes DNP-Verfahren realisiert. Insbesondere ermöglicht ein derartig gepulstes Verfahren eine besonders flexible Ausgestaltung der Sequenz, da eine Anzahl von unterschiedlichen Polarisationsschemata in einfacher Art und Weise durch eine Variation der Folge von Hochfrequenzpulsen realisierbar ist.

Zwischen den Hochfrequenzpulsen der Sequenz können auch gleiche Zeitdauern eingesetzt werden. Dadurch wird der Aufbau der Sequenz vereinfacht. Die Zeitdauern sind hierbei invers proportional zu der Larmorfrequenz der ersten Spinmomente im Magnetfeld. Mit anderen Worten werden die Hochfrequenzpulse im Wesentlichen periodisch und äquidistant während der Sequenz erzeugt.

Die Sequenz wird hierbei vorzugsweise wiederholt, wobei vor jeder Sequenz das zweite Spinmoment zweckmäßigerweise erneut entlang des Magnetfeldes polarisiert wird. Durch die Einwirkung oder Bestrahlung des zweiten Spinmoments mit der Sequenz wird die Ausrichtung beziehungsweise die Polarisation des zweiten Spinmoments auf ein wechselwirkendes erstes Spinmoment übertragen, sodass durch die Wiederholung zunehmend mehr erste Spinmomente polarisiert werden. Zusätzlich oder alternativ ist es beispielsweise denkbar, dass mehrere zweite Spinmomente eingesetzt und gleichzeitig mit der Sequenz bestrahlt werden, sodass bei einer Ausführung der Sequenz mehrere erste Spinmomente im Wesentlichen gleichzeitig polarisiert werden. Dadurch wird die geordnete Ausrichtung der ersten Spinmomente durch die Anwendung des Verfahrens gegenüber der thermischen Polarisierung der ersten Spinmomente (Gleichgewichtsmagnetisierung) im homogenen Magnetfeld wesentlich erhöht.

Die Erfindung geht hierbei von der Erkenntnis aus, dass die Einwirkung eines (resonanten) Hochfrequenzpulses den Spinzustand des zweiten Spinmoments verändert, wobei die insbesondere dipolare Wechselwirkung zwischen den ersten und zweiten Spinmomenten in den Zeitdauern vor und nach dem Hochfrequenzpuls somit einen unterschiedlichen Einfluss auf die Spindynamik des zweiten Spinmoments bewirkt. Unter Spindynamik ist hierbei insbesondere die freie Bewegung (Evolution) des zweiten Spinmoments - das bedeutet ohne Einwirkung eines Hochfrequenzpulses - unter Einwirkung des Magnetfeldes und der Wechselwirkung mit den ersten Spinmomenten zu verstehen. Zu diesem Zwecke wird das polarisierte zweite Spinmoment zu Beginn der Sequenz geeigneterweise mittels eines Initialisierungs-Hochfrequenzpulses mit einem 90°-Flipwinkel in einen Superpositions-Zustand gebracht. Die nachfolgenden Pulse kontrollieren nun die Phase und die Amplitude der Wechselwirkung zwischen den Spinmomenten, welche zwischen den Pulsen stattfindet. Im Wesentlichen erfolgt der Polarisationstransfer somit nicht während der Einwirkung der Hochfrequenzstrahlung, sondern aufgrund der Spindynamiken während den Zeitdauern oder Pulspausen (Pulsabstand) zwischen zwei benachbarten Hochfrequenzpulsen. Insbesondere wird der Polarisationstransfer durch die Summe oder Aneinanderreihung der einzelnen Spindynamiken während den Zeitdauern ermöglicht. Dies bedeutet insbesondere, dass die Pulsdauer und Pulsamplitude der Hochfrequenzpulse im Wesentlichen unabhängig von der Hartmann-Hahn-Bedingung sind. Die Hochfrequenzpulse sind somit vorzugsweise auf einer kürzeren Zeitskala als die Wechselwirkungsstärke zwischen den ersten und zweiten Spinmomenten einwirkbar, sodass die Spindynamiken zuverlässig kontrollierbar sind.

Mit anderen Worten erfolgt der erfindungsgemäße Polarisationstransfer im Gegensatz zum Stand der Technik nicht während eines Hochfrequenzpulses, sondern insbesondere am Ende der gesamten (Puls-)Sequenz als Resultat der konstruktiven Addition der einzelnen Spindynamiken zu einer polarisierenden Gesamtspindynamik des zweiten Spinmoments. Dies bedeutet, dass das zweite Spinmoment durch die Sequenz im Wesentlichen derart bewegt wird, dass aufgrund der durch die Wechselwirkung mit den ersten Spinmomenten beeinflussten Spindynamik ein Flip-Flop-Prozess (Polarisationsaustausch) zwischen dem zweiten Spinmoment und dem ersten Spinmoment ermöglicht wird. Mit anderen Worten ist der Nettoeffekt der gesamten Evolution am Ende der Sequenz ein Flip-Flop-Prozess zwischen einem ersten und dem zweiten Spinmoment.

Durch das erfindungsgemäße Verfahren ist es somit ermöglicht, einen Polarisationstransfer unabhängig von der Hartmann-Hahn-Bedingung zu bewirken. Dadurch wird die Flexibilität und Robustheit des Verfahrens gegenüber herkömmlichen gepulsten DNP-Verfahren verbessert. Der Polarisationstransfer wird insbesondere durch die Evolution zwischen den Hochfrequenzpulsen, das bedeutet durch den Pulsabstand, bewirkt. Der Pulsabstand zwischen den Hochfrequenzpulsen ist vergleichsweise einfach kontrollierbar, sodass die technischen Anforderungen zur Durchführung der Hyperpolarisierung im Vergleich zum Stand der Technik weiter reduziert werden.

Des Weiteren ermöglicht das erfindungsgemäße Verfahren einen Polarisationstransfer von dem zweiten Spinmoment auf ein (Spin-)Ensemble aus ersten Spinmomenten, wobei die Stärke der Wechselwirkungen zwischen dem zweiten Spinmoment und den einzelnen ersten Spinmomenten im Wesentlichen unbekannt sind.

Da die Hochfrequenzpulse lediglich kurzzeitig oder abschnittsweise auf das zweite Spinmoment einwirken, werden die Anforderungen hinsichtlich der Stabilität und Genauigkeit der Pulsamplitude und/oder Pulsfrequenz vorteilhaft reduziert. Dadurch können Hochfrequenzpulse mit besonders hoher Pulsamplitude und/oder kurzer Pulsdauer eingesetzt werden. Dies ist insbesondere vorteilhaft, wenn Fluktuationen des Magnetfeldes (Magnetfeldstärke, Magnetfeldrichtung) auftreten und/oder wenn das zweite Spinmoment eine vergleichsweise große spektrale Linienbreite, beispielsweise aufgrund von Hyperfeinwechselwirkungen oder einem nicht-isotropischen g-Tensor, aufweist.

Als erste Spinmomente werden vorzugsweise (atomare) Kernspinmomente und als zweites Spinmoment ein Elektronenspinmoment verwendet. Wesentlich ist, dass die ersten und zweiten Spinmomente unterschiedliche gyromagnetische Verhältnisse aufweisen, das bedeutet, dass sie im Magnetfeld eine unterschiedliche Larmorfrequenz aufweisen. Dadurch ist das zweite Spinmoment mittels der Hochfrequenzpulse kohärent oder resonant manipulierbar, ohne dass dabei die ersten Spinmomente durch die Hochfrequenzbestrahlung beeinflusst werden. Mit anderen Worten ist das zweite Spinmoment unabhängig von den ersten Spinmomenten manipulierbar.

Die Hochfrequenzbestrahlung beziehungsweise die Hochfrequenzpulse sind in dieser Ausführung insbesondere elektromagnetische Wechselfelder mit einer Frequenz etwa gleich der Larmorfrequenz der zweiten Spinmomente (Elektronenspinmomente) im Magnetfeld. Die Frequenz liegt hierbei beispielsweise im Mikrowellenbereich, das bedeutet im Megahertz- bis Gigahertz-Bereich. Vorzugsweise weisen jedoch die Hochfrequenzpulse zur Manipulation der zweiten Spinmomente stets eine Amplitude auf, deren Rabifrequenz höher ist, als die Larmorfrequenz der ersten Spinmomente im Magnetfeld. Bei einer kohärenten und insbesondere resonanten Anregung eines Spinmoments mit einer Hochfrequenzbestrahlung, oszilliert die Besetzung zwischen den zwei resonanten Zuständen mit der sogenannten Rabifrequenz. Je höher die Amplitude der Hochfrequenzbestrahlung, desto höher die resultierende Rabifrequenz.

In einer möglichen Ausführungsform sind die ersten und zweiten Spinmomente Teil einer gemeinsamen Molekülstruktur eines Moleküls oder einer gemeinsamen Gitterstruktur eines Festkörpers als Materialprobe, beispielsweise für eine als Festkörper-NMR-Analyse ausgebildete Magnetresonanz-Analyse. Ebenso denkbar ist eine Anwendung, bei welcher insbesondere das zweite Spinmoment Teil eines freien Mono- oder Biradikalmoleküls oder eines metallischen Ions ist. Geeignete Moleküle oder Ionen sind hierbei beispielsweise Gadoliniumionen ($Gd^{3+}$), TRITYL, TEMPO, BDPA, BTnE oder TOTAPOL.

In einer vorteilhaften Ausführung wird zur Manipulation des zweiten Spinmoments eine Sequenz erzeugt, deren sich aus den einzelnen Zeitdauern zwischen den Hochfrequenzpulsen zusammensetzende Gesamtsequenzdauer zur Bewirkung des Polarisationstransfers kürzer ist, als eine Zeitdauer, welche invers proportional zu der Stärke einer Wechselwirkung zwischen den Spinmomenenten ist (Polarisationstransferdauer). Mit anderen Worten wird mit der Sequenz verfahrensgemäß ein Polarisationstransfer zwischen den ersten und zweiten Spinmomenten bewirkt, dessen Polarisationsdynamik auf einer Zeitskala erfolgt, die Wesentlich kürzer ist, als eine durch die Wechselwirkungsstärke zwischen den Spinmomenten vorgegebene Polarisationstransferdauer. Vorzugsweise erfolgt die bewirkte Polarisationsdynamik hierbei auf einer Zeitskala, welche vergleichbar mit der Larmorperiode der ersten Spinmomente im Magnetfeld ist. Dies bedeutet insbesondere auch, dass im Gegensatz zu NOVEL die Pulsdauer der Hochfrequenzpulse wesentlich geringer ist als die Polarisationstransferdauer. Dadurch ist ein besonders zeitsparendes und effektives Verfahren zur Hyperpolarisation gewährleistet, welches insbesondere auch für eine Hyperpolarisierung von Spinensemblen, mit einer Vielzahl von wechselwirkenden ersten und zweiten Spinmomenten, eignet und ausgestaltet ist.

In einer geeigneten Weiterbildung wird für jeden Hochfrequenzpuls der Sequenz lediglich ein Flipwinkel von 90° und/oder 180° eingesetzt. Dadurch ist eine besonders einfache und aufwandsarme Sequenz für das Verfahren realisiert.

In einer vorteilhaften Ausgestaltung werden die Hochfrequenzpulse entlang zweier zueinander senkrecht orientierten Pulsachsen erzeugt. Dadurch sind Pulsfehler der Hochfrequenzpulse wie beispielsweise Ungenauigkeiten in der Phasenlage und/oder Amplitude und/oder Flipwinkel ausgleich- beziehungsweise kompensierbar, sodass eine besonders stabile und fehlerunanfällige Sequenz ermöglicht wird. Als senkrecht orientierte Pulsachsen werden vorzugsweise eine X- und eine Y-Pulsachse verwendet.

Unter einer Pulsachse ist hierbei insbesondere eine Pulsrichtung in einem rotierenden Bezugssystem zu verstehen, das bedeutet eine Phasenlage, entlang welcher ein Hochfrequenzpuls ausgeübt beziehungsweise eingewirkt wird. Ein Hochfrequenzpuls entlang einer X-Pulsachse ist hierbei insbesondere ein Hochfrequenzpuls, welcher im rotierenden Bezugssystem eine Phasenlage von 0° aufweist. Entsprechend ist ein Hochfrequenzpuls entlang einer Y-Pulsachse insbesondere ein Hochfrequenzpuls, welcher hierzu im rotierenden Bezugssystem eine (relative) Phasenlage von 90° aufweist. Die Z-Pulsachse ist hierbei im Wesentlichen stets entlang des Magnetfeldes orientiert. Mit anderen Worten bestimmt der erste Hochfrequenzpuls der Sequenz im Wesentlichen die (relative) Phasenlage und somit Pulsrichtung der nachfolgenden Hochfrequenzpulse.

In einer besonders stabilen Ausgestaltung des Verfahrens ist vorgesehen, dass ein Hochfrequenzpuls der Sequenz als ein Composite-Puls ausgeführt ist. Unter einem Composite-Puls ist in diesem Zusammenhang ein zusammengesetzter Hochfrequenzpuls zu verstehen, bei welchem mehrere einzelne Hochfrequenzpulse entlang unterschiedlicher Pulsachsen im Wesentlichen unmittelbar - das bedeutet ohne eine dazwischen eingebrachte Zeitdauer - aneinandergereiht werden, sodass bei einem Einwirken des Composite-Pulses ein effektiver Flipwinkel ausgeführt wird. Dadurch werden Pulsfehler der Hochfrequenzpulse besser kompensiert, wodurch der Polarisationstransfer verbessert wird. In einer möglichen Ausgestaltungsform sind beispielsweise mehrere oder alle Hochfrequenzpulse der Sequenz als Composite-Pulse ausgeführt.

Zusätzlich oder alternativ ist es hierbei beispielsweise denkbar, die (einhüllende) Pulsform eines Hochfrequenz- oder Composite-Pulses zu variieren beziehungsweise anzupassen. Dies bedeutet, dass die Pulsform beispielsweise rechteckförmig, gaussförmig, oder sinc-förmig ist. In einer besonders geeigneten Ausgestaltungsform ist die Pulsform insbesondere hinsichtlich einer optimalen Steuerung (optimal control) des zweiten Spinmoments ausgestaltet, sodass eine besonders effektive und zuverlässige Manipulation des zweiten Spinmoments gewährleistet ist. Zur Optimierung der Pulsform werden hierbei beispielsweise numerische Verfahren eingesetzt.

Ein zusätzlicher oder weiterer Aspekt der Erfindung sieht vor, dass das zweite Spinmoment zur Polarisierung oder Ausrichtung entlang des Magnetfeldes optisch polarisiert wird. Unter einer optischen Polarisierung ist hierbei eine Ausrichtung oder Anordnung des Spinmoments während einer Beleuchtung oder Bestrahlung mit (Laser-)Licht in einem optisch sichtbaren oder auch nicht sichtbaren Wellenlängenbereich zu verstehen.

Zu diesem Zwecke ist das zweite Spinmoment geeigneterweise in einer Systemmatrix, wie beispielsweise einem Molekül oder einem Festkörper eingebettet, wodurch eine Energielevelstruktur für das zweite Spinmoment ausgebildet wird, welche bei einer optischen Bestrahlung eine bevorzugte Polarisierung des Spinmoments entlang des Magnetfeldes erzeugt.

Mit anderen Worten wird das Spinmoment durch die optische Bestrahlung in einem bestimmten (Spin-)Zustand präpariert. Dadurch wird es möglich, das Verfahren schneller auszuführen und zu wiederholen, da zur Ausrichtung des zweiten Spinmoments am Magnetfeld lediglich ein optischer Lichtpuls benötigt wird. Somit muss insbesondere bei einer Wiederholung der Sequenz nicht die longitudinale Relaxationszeit ($T_1$-Zeit) des zweiten Spinmoments abgewartet werden.

In einer möglichen Ausgestaltung wird als zweites Spinmoment ein Elektronenspinmoment eines Farbzentrums einer Festkörperprobe verwendet. Unter einem Farbzentrum ist hierbei ein Punkt- oder Gitterdefekt im Festkörpergitter der Festkörperprobe zu verstehen, welcher optisch sichtbares Licht absorbiert. Vorzugsweise ist das zweite Spinmoment des Farbzentrums hierbei optisch polarisierbar. Die ersten Spinmomente der Materialprobe werden geeigneterweise mit dem zweiten Spinmoment der Festkörperprobe in Wechselwirkung gebracht, indem die Proben miteinander in Kontakt gebracht werden. Beispielsweise ist die Festkörperprobe ein Nanopartikel, welcher einer flüssigen Materialprobe als Suspension beigemischt wird.

Ein geeignetes Farbzentrum ist in diesem Zusammenhang beispielsweise das Stickstofffehlstellenzentrum (nitrogen vacancy centre, NV-Zentrum) in Diamant beziehungsweise in einem Nanodiamant. Ebenso denkbar sind beispielsweise Siliziumoxidfehlstellen und Siliziumfehlstellen (silicon vacancy, SiV) in Siliziumcarbid. Alternativ sind beispielsweise auch Oxidfehlstellen in Zinkoxid mögliche Farbzentren mit einem optisch polarisierbaren Elektronenspinmoment.

In einer alternativen Ausgestaltungsform wird als zweites Spinmoment ein Elektronenspinmoment eines photoanregbaren Triplet-Zustand-Moleküls verwendet. Derartige Moleküle sind beispielsweise Tetraphenylprophyrin, H2TPP oder ZNTPP in nicht polaren Lösungsmitteln wie beispielsweise Mineralöl oder Benzen, oder Pentacen und Anthracen in Lösungen mit Benzen oder Paradichlorbenzen.

Ein zusätzlicher oder weiterer Aspekt der Erfindung sieht vor, dass während der Sequenz ein Sequenzabschnitt erzeugt wird, welcher mindestens eine Sequenzeinheit umfasst. Hierbei ist es beispielsweise denkbar, dass zur Bewirkung des Polarisationstransfers mittels der Gesamtdynamiken der Sequenz, die Sequenz aus einzelnen ineinander verschachtelt oder nacheinander ausgeführten Sequenzabschnitten beziehungsweise -einheiten zusammengesetzt ist, welche beispielsweise jeweils mehrfach wiederholbar sind.

Die Sequenzeinheit weist hierbei eine Sequenzeinheitsdauer auf, welche ein ungeradzahliges Vielfaches einer halben Larmorperiode der ersten Spinmomente im Magnetfeld ist. Zusätzlich oder alternativ ist es vorgesehen, dass die Hochfrequenzpulse aufeinanderfolgender Sequenzeinheiten einen relativen Zeitversatz gegeneinander aufweisen. Unter einer Sequenzeinheitsdauer ist hierbei insbesondere die Gesamtzeitdauer (Pulsdauern und Zeitabstände) der jeweiligen Sequenzeinheit zu verstehen.

Bei einem Übergang von einer ersten Sequenzeinheit auf eine nachfolgende zweite Sequenzeinheit sind hierbei ein oder mehrere Hochfrequenzpulse vorgesehen, mittels welchen eine parallel zum Magnetfeld orientierte Ausrichtung des zweiten Spinmoments in eine senkrecht zum Magnetfeld orientierte Ebene gedreht wird. Der oder die Hochfrequenzpulse sind in einer möglichen Ausbildungsform am Ende der jeweiligen Sequenzeinheit angeordnet oder sind alternativ als zwischen den Sequenzeinheiten eingebrachte Zwischenpulse ausgeführt, dies bedeutet, dass die einzelnen Sequenzeinheiten mittels einen oder mehrerer Zwischenpulse voneinander getrennt sind.

In einer denkbaren Weiterbildungsform ist es beispielsweise denkbar, dass der oder die Hochfrequenzpulse beim Übergang zwischen den Sequenzabschnitten in der Wirkung einen von 180° verschiedenen Flipwinkel des zweiten Spinmoments bewirken. Dadurch wird sichergestellt, dass eine Magnetisierung entlang der Z-Achse des zweiten Spinmoments in eine nicht-parallele Orientierung zur Z-Achse gedreht wird. Dies ist wichtig für die zu bewirkende Polarisationsdynamik.

Der oder die Hochfrequenzpulse realisieren hierbei vorzugsweise einen Flipwinkel des zweiten Spinmoments, welcher das zweite Spinmoment in eine X-Y-Ebene, das bedeutet eine transversal orientierte Ebene, senkrecht zu dem Magnetfeld, dreht. Vorzugsweise wird zusätzlich die Phase der ersten Spinmomente aufgrund ihrer Larmorpräzession im Magnetfeld zwischen den Sequenzeinheiten um insbesondere 90° phasenversetzt. Dies ist beispielsweise mittels eines zusätzlichen Zeitversatzes zwischen den Hochfrequenzpulsen der beteiligten Sequenzeinheiten realisierbar, welcher eine Zeitdauer gleich einem ungeraden Vielfachen der halben Larmorperiode der ersten Spinmomente aufweist. Ebenso denkbar ist es, dass ein derartiger Zeit- oder Phasenversatz dadurch bewirkt wird, dass die Sequenzeinheitsdauern der jeweiligen Sequenzeinheiten gleich einem ungeraden Vielfachen der halben Larmorperiode der ersten Spinmomente im Magnetfeld sind.

In einer möglichen Ausführung des Verfahrens wird während der Sequenz ein Sequenzabschnitt erzeugt, bei welchem vier mittels gleicher Zeitdauern gegeneinander versetzte Hochfrequenzpulse mit jeweils einem 90°-Flipwinkel aufeinanderfolgen. Dadurch ist ein besonders einfacher und schneller Polarisationstransfer ermöglicht. Der Sequenzabschnitt ist hierbei beispielsweise aus vier identischen Sequenzeinheiten zusammengesetzt, wobei jede Sequenzeinheit im Wesentlichen eine Zeitdauer und einen Hochfrequenzpulse mit 90°-Flipwinkel umfasst.

In einer denkbaren Ausgestaltung wird während der Sequenz ein Sequenzabschnitt erzeugt, bei welchem eine Anzahl von mittels gleicher Zeitdauern gegeneinander versetzten Hochfrequenzpulsen mit jeweils einem 180°-Flipwinkel aufeinanderfolgen, wobei die Hochfrequenzpulse abwechselnd als Composite-Pulse ausgebildet sind. Beispielsweise werden hierbei abwechselnd Hochfrequenzpulse entlang einer X-Pulsachse und Composite-Pulse entlang einer Composite-Pulsachse erzeugt. Dadurch ist eine besonders flexible Sequenz realisierbar, was sich vorteilhaft auf die Effektivität des Polarisationstransfers überträgt. Der Sequenzabschnitt umfasst hierbei geeigneterweise eine Anzahl von aufeinanderfolgenden Sequenzeinheiten, welche jeweils aus einem Hochfrequenzpulse mit 180° Flipwinkel um die X-Pulsachse und einem Composite-Puls um die Composite-Pulsachse sowie den zugeordneten Zeitdauern zusammengesetzt sind.

In einer geeigneten Weiterbildung werden während der Sequenz aufeinanderfolgend ein erster Sequenzabschnitt und ein Hochfrequenzpuls mit 90°-Flipwinkel (Zwischenpuls) sowie ein zweiter Sequenzabschnitt erzeugt. Während der Sequenzabschnitte wird jeweils eine Anzahl von mittels gleicher Zeitdauern gegeneinander versetzten Hochfrequenzpulse mit jeweils einem 180°-Flipwinkel aufeinanderfolgend erzeugt. Die Zeitdauern des zweiten Sequenzabschnitts weisen hierbei einen relativen Zeitversatz zu den Zeitdauern des ersten Sequenzabschnitts auf. Die Hochfrequenzpulse werden hierbei während den Sequenzabschnitten geeigneterweise alternierend oder wechselnd - beispielsweise nach Art einer XY-Entkopplungssequenz - entlang der X- und Y-Pulsachse erzeugt, wodurch die Stabilität und Zuverlässigkeit des dadurch bewirkten Polarisationstransfers verbessert wird. Ebenso denkbar ist es, dass die Sequenzabschnitte in Form anderer Entkopplungssequenzen, wie beispielsweise einer CPMG-Sequenz (Carr-Purcell-Meiboom-Gill) oder KDD-Sequenz (Knill dynamical decoupling), ausgestaltet sind.

Der erste Sequenzabschnitt weist hierbei bezüglich der Zeitdauern und der Hochfrequenzpulse einen im Wesentlichen symmetrischen Aufbau auf, wobei der zweite Sequenzabschnitt durch den Zeitversatz einen hierzu nicht symmetrischen Aufbau aufweist. Der Zeitversatz ist hierbei insbesondere zwischen dem Hochfrequenzpuls mit 90°-Flipwinkel zwischen den Sequenzabschnitten und dem ersten Hochfrequenzpuls des zweiten Sequenzabschnitts eingebracht. Mit anderen Worten weist die Zeitdauer zwischen dem Hochfrequenzpuls zwischen den Sequenzabschnitten und dem ersten Hochfrequenzpuls des zweiten Sequenzabschnitts eine um den Zeitversatz längere Zeitdauer auf als die Zeitdauer zwischen dem letzten Hochfrequenzpuls des ersten Sequenzabschnitts zu dem Hochfrequenzpuls zwischen den Sequenzabschnitten.

In einer vorteilhaften Ausbildung werden während der Sequenz unmittelbar aufeinanderfolgend ein erster Sequenzabschnitt und ein zweiter Sequenzabschnitt erzeugt. Dies bedeutet, dass der erste Hochfrequenzpuls des zweiten Sequenzabschnitts unmittelbar auf den letzten Hochfrequenzpuls des ersten Sequenzabschnitts folgt. Mit anderen Worten ist zwischen den beiden Sequenzabschnitten keine Zeitdauer vorgesehen. Während der Sequenzabschnitte werden jeweils zwei Hochfrequenzpulse mit einem 90°-Flipwinkel erzeugt, zwischen denen mittig jeweils ein Hochfrequenzpuls mit einem 180°-Flipwinkel angeordnet ist. Im ersten Sequenzabschnitt werden die Hochfrequenzpulse mit einem 90°-Flipwinkel entlang einer ersten Pulsachse und der Hochfrequenzpuls mit einem 180°-Flipwinkel entlang einer senkrecht zur ersten Pulsachse orientierten zweiten Pulsachse erzeugt. In dem nachfolgenden zweiten Sequenzabschnitt werden die Hochfrequenzpulse mit einem 90°-Flipwinkel entlang der zweiten Pulsachse und der Hochfrequenzpuls mit einem 180°-Flipwinkel entlang der negativen ersten Pulsachse erzeugt. In dieser Ausführungsform sind keine zusätzlichen Anfangs- oder Endpulse der Sequenz notwendig.

In einer geeigneten Ausgestaltung werden der oder die Sequenzabschnitte während der Sequenz mehrmals aufeinanderfolgend wiederholt. Die Gesamtzeit für einen erfolgreichen Polarisationstransfer, das bedeutet die (Gesamt-)Dauer aller einzelnen Zeitdauern der Sequenz, ist geeigneterweise proportional zu der Stärke der Wechselwirkung zwischen dem zweiten Spinmoment und den ersten Spinmomenten. Durch die Wiederholungen der Sequenzabschnitte ist es somit möglich, die Gesamtdauer der Sequenz an die benötigte Gesamtzeit für den Polarisationstransfer flexibel anzupassen. Dadurch ist ein besonders effektives Verfahren zur Hyperpolarisierung gewährleistet.

In einer bevorzugten Anwendung wird das Verfahren in einer Vorrichtung zur Hyperpolarisierung einer Materialprobe vor und/oder während einer Magnetresonanz-Analyse eingesetzt. Die Vorrichtung ist beispielsweise ein NMR-Spektrometer oder ein bildgebendes NMR-Gerät. Durch das erfindungsgemäße Verfahren wird der Anteil der ausgerichteten ersten Spinmomente in der Materialprobe einfach erhöhbar, sodass eine höhere Anzahl von ersten Spinmomenten zu einem Messsignal der Magnetresonanz-Analyse beitragen. Dadurch wird die Genauigkeit und Auflösung der Magnetresonanz-Analyse kostengünstig und aufwandarm verbessert. Des Weiteren werden die Kosten zur Herstellung und/oder Betrieb der Vorrichtung vorteilhaft reduziert, da durch die Anwendung des erfindungsgemäßen Verfahrens die technischen Anforderungen hinsichtlich Stabilität und Genauigkeit der Hochfrequenzpulse oder des Magnetfeldes reduziert werden.

Nachfolgend sind Ausführungsbeispiele der Erfindung anhand einer Zeichnung näher erläutert. Darin zeigen in schematischen und vereinfachten Darstellungen:

| Fig. 1 | eine Vorrichtung zur Hyperpolarisierung einer Materialprobe für eine Kernspinresonanz-Analyse, |
| Fig. 2 | ausschnittsweise die Materialprobe mit einer Anzahl von Kernspinmomenten und mit einem Nanodiamanten mit einem optisch polarisierbaren Elektronenspinmoment, |
| Fig. 3 | eine Sequenz von Hochfrequenzpulsen zur Hyperpolarisierung der Materialprobe, |
| Fig. 4 | ein erstes Ausführungsbeispiel der Sequenz mit einem Sequenzabschnitt mit vier aufeinanderfolgenden Hochfrequenzpulsen mit 90°-Flipwinkeln, |
| Fig. 5 | ein zweites Ausführungsbeispiel der Sequenz mit einem Sequenzabschnitt mit abwechselnden Hochfrequenzpulsen mit 180°-Flipwinkeln und Y-Z-Composite-Pulsen, |
| Fig. 6 | den Aufbau eines Y-Z-Composite-Pulses, |
| Fig. 7 | ein drittes Ausführungsbeispiel der Sequenz mit einem ersten Sequenzabschnitt und mit einem Hochfrequenzpuls mit 90°-Flipwinkel sowie mit einem zweiten Sequenzabschnitt, |
| Fig. 8 | ein viertes Ausführungsbeispiel der Sequenz mit zwei Sequenzabschnitten mit jeweils zwei Hochfrequenzpulsen mit 90°-Flipwinkel sowie mit einem dazwischen angeordneten Hochfrequenzpuls mit 180°-Flipwinkel, und |
| Fig. 9a und 9b | eine Simulation der Robustheit der Sequenz gemäß Fig. 8. |

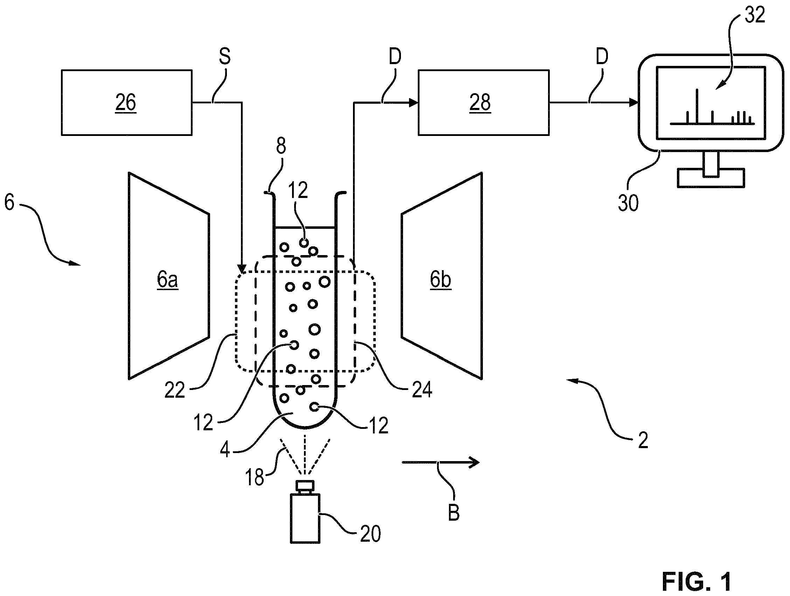

Einander entsprechende Teile und Größen sind in allen Figuren stets mit den gleichen Bezugszeichen versehen.
Die in der Fig. 1 dargestellte Vorrichtung 2 ist zur Hyperpolarisierung einer Materialprobe 4 geeignet und eingerichtet. Hierzu ist die Vorrichtung 2 insbesondere als ein NMR-Spektrometer zur Magnetresonanz- beziehungsweise Kernspinresonanz-Analyse der Materialprobe 4 ausgeführt. Die Vorrichtung 2 umfasst einen elektrischen und/oder supraleitenden Magneten 6, mit einem Nordpol 6a und einem Südpol 6b, zwischen welchen im Betrieb ein homogenes Magnetfeld B erzeugt wird. Zur Hyperpolarisierung und/oder Analyse der Materialprobe 4 wird diese in den zwischen den Nordpol 6a und Südpol 6b freigestellten Bereichs positioniert.

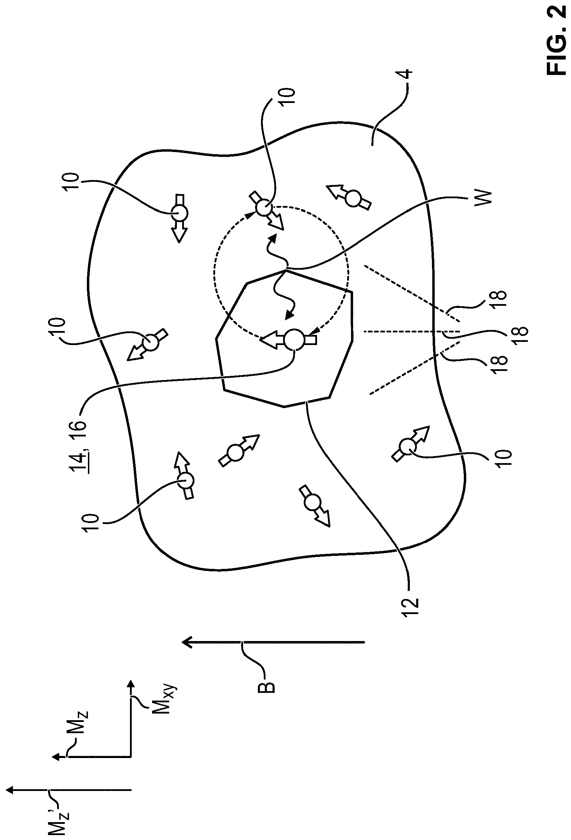

Die Materialprobe 4 ist in diesem Ausführungsbeispiel beispielhaft als eine flüssige Probe in einem (nicht magnetischen) Probenbehälter 8 ausgeführt. Wie in der Fig. 2 vereinfacht und schematisch dargestellt weist die Materialprobe 4 eine Anzahl von Spinmomenten 10, insbesondere Kernspinmomenten, auf. Die Kernspinmomente 10 sind in der Fig. 2 lediglich beispielhaft mit Bezugszeichen versehen.

In diesem Ausführungsbeispiel ist der Materialprobe 4 eine Anzahl von Festkörperproben beziehungsweise Nanopartikeln 12, insbesondere Nanodiamanten, als Suspension beigemischt, welche vorzugsweise jeweils mindestens ein Farbzentrum 14 mit einem optisch polarisierbaren Spinmoment 16, insbesondere einem Elektronenspinmoment, aufweisen. In der Fig. 2 ist beispielhaft lediglich ein Nanodiamant 12 mit einem Elektronenspinmoment 16 eines Farbzentrums 14 dargestellt. Das Farbzentrum 14 ist beispielsweise ein NV-Zentrum (nitrogen vacancy centre), welches mit einem Laserlicht 18 eines Lasers 20 entlang einer Polarisierungsachse, welche in Fig. 2 beispielhaft parallel zu dem Magnetfeld B orientiert ist, ausrichtbar ist.

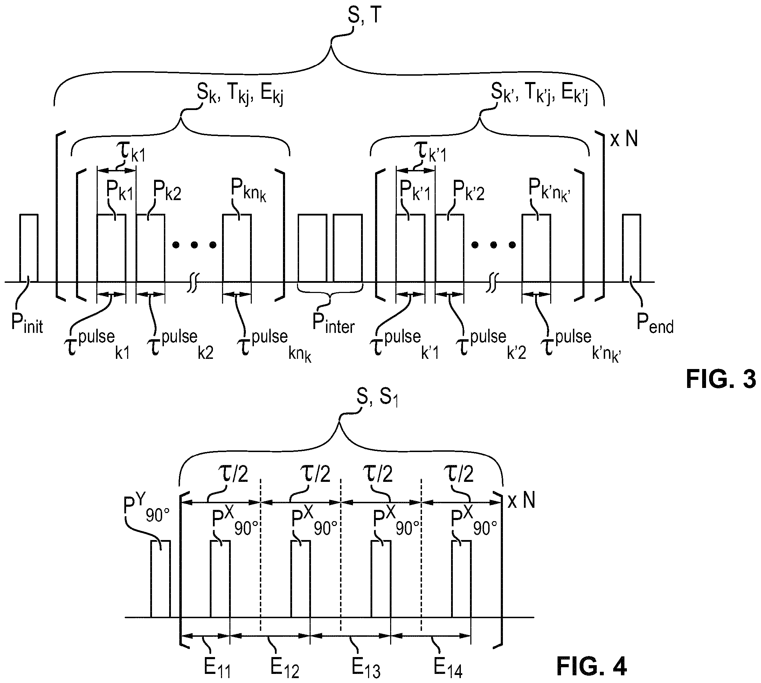

Die Materialprobe 4 beziehungsweise der Probenbehälter 8 sind im Montagezustand zumindest teilweise von einer punktiert dargestellten Anregungsspule 22 und von einer strichliniert dargestellten Detektionsspule (pick-up coil) 24 umgriffen. Die Anregungsspule 22 ist an einen Hochfrequenzgenerator 26 angebunden, und erzeugt im Betrieb eine (Puls-)Sequenz S mit einer Anzahl von Hochfrequenzpulsen (Fig. 3) einer bestimmten Frequenz, Pulsdauer, Pulsamplitude und Pulsphasenlage.

Die Hochfrequenzpulse sind vorzugsweise resonant mit den Elektronenspinmomenten 16 der Nanodiamanten 12, das bedeutet, die Frequenz der Hochfrequenzpulse ist an die Larmorfrequenz der Elektronenspinmomenten 16 im Magnetfeld B angepasst. Insbesondere werden die Kernspinmomente 10 der Materialprobe 4 von den Hochfrequenzpulsen der Sequenz S im Wesentlichen nicht beeinflusst. Die Hochfrequenzpulse sind elektromagnetische Wechselfelder, welche im Wesentlichen transversal, das bedeutet senkrecht, zum Magnetfeld B orientiert sind.

Die Detektionsspule 24 ist zum Empfangen und Detektieren des von den Kernspinmomenten 10 erzeugten magnetischen Wechselfeldes während einer NMR-Analyse ausgeführt. Hierzu ist die Detektionsspule 24 beispielsweise als eine Faraday-Spule ausgeführt, welche das detektierte NMR-Signal D über einen Receiver 28 an ein Anzeigegerät 30 zur Analyse und Darstellung eines NMR-Spektrums 32 der Kernspinmomente 10 der Materialprobe 4 sendet. In einer alternativen Ausgestaltungsform sind die Anregungsspule 22 und die Detektionsspule 24 beispielsweise in einer gemeinsamen Spule ausgeführt.

Im Betrieb der Vorrichtung 2 ist die Materialprobe 4 im Magneten 6 positioniert. Durch das Magnetfeld B werden die Kernspinmomente 10 der Materialprobe 4 zumindest teilweise entlang des Magnetfeldes B ausgerichtet. Mit anderen Worten stellt sich eine thermische Gleichgewichtsverteilung der Kernspinmomente 10 ein, wobei sich eine Gleichgewichtsmagnetisierung $M_z$ der Kernspinmomente 10 ausbildet welche parallel zu dem Magnetfeld B orientiert ist.

Im Zuge der NMR-Analyse wird die Gleichgewichtsmagnetisierung $M_z$ in eine Transversalmagnetisierung $M_{xy}$ überführt, deren Präzession im Magnetfeld B das NMR-Signal D in der Detektionsspule 24 induziert. Zur Verbesserung des NMR-Signals D ist es daher wünschenswert, dass eine möglichst große Transversalmagnetisierung $M_{xy}$ erzeugt wird. Dadurch wird eine Erhöhung der (longitudinalen) Gleichgewichtsmagnetisierung $M_z$ der Kernspinmomente 10 notwendig. Zu diesem Zwecke wird die Sequenz S zur Hyperpolarisierung der Kernspinmomente 10, das bedeutet die Erzeugung einer geordneten Ausrichtung der Kernspinmomente 10 in der Materialprobe 4 weit über die thermische Gleichgewichtsverteilung hinaus, ausgeführt. Mit anderen Worten wird durch die Einwirkung der Sequenz S vor und/oder während der NMR-Analyse eine erhöhte Magnetisierung $M_z'$ erzeugt, welche einen höheren Polarisationsgrad beziehungsweise Polarisation als die Gleichgewichtsmagnetisierung $M_z$ aufweist.

Durch die Sequenz S wird hierbei die Polarisierung der Elektronenspinmomente 16 der beigefügten Nanopartikel 12 auf die Kernspinmomente 10 übertragen. Dieser Polarisationstransfer ist in der Fig. 2 strichliniert schematisch dargestellt. Die Elektronenspinmomente 16 werden hierzu zunächst mittels des Laserlichts 18 optisch polarisiert und anschließend mittels der eingestrahlten Sequenz S kohärent manipuliert. Wie in Fig. 2 lediglich beispielhaft dargestellt, ist das jeweilige Elektronenspinmoment 16 mittels einer dipolaren Wechselwirkung W an die Kernspinmomente 10 in dessen Umgebung gekoppelt.

Der Polarisationstransfer von dem Elektronenspinmoment 16 auf das Kernspinmoment 10 erfolgt hierbei nicht während eines Hochfrequenzpulses, sondern insbesondere am Ende der Sequenz S aufgrund der dadurch bewirkten, totalen beziehungsweise angesammelten Spindynamik. Mit anderen Worten wird das Elektronenspinmoment 16 mittels der Sequenz S im Wesentlichen derart manipuliert, dass aufgrund der Wechselwirkung W mit dem Kernspinmoment 10 ein Flip-Flop-Prozess ermöglicht wird. Hierzu ist es im Wesentlichen notwendig, dass die Sequenz S einen effektiven Hamiltonian $H_{eff}$ erzeugt, welcher die benötigte Spindynamik bewirkt.

Für den Polarisationstransfer wird insbesondere ein effektiver Hamiltonian $H_{eff}$ der Form

$$H_{eff} = -\frac{1}{\pi} A_x \left( I_x S_x + I_y S_y \right) = -\frac{A_x}{2\pi} \left( I_+ S_- + I_- S_+ \right)$$

benötigt, wobei $A_x$ die transversal Wechselwirkungsstärke aufgrund der Wechselwirkung W und $\pi$ die Kreiszahl ist. Die Spinoperatoren des Kernspinmoments 10 sind hierbei als $I_x$, $I_y$, $I_+$ und I. bezeichnet, wobei die Spinoperatoren des Elektronenspinmoments 16 entsprechend mit $S_x$, $S_y$, $S_+$ und $\dot{S}$. beschrieben sind. Der Hamiltonian $H_{eff}$ ist hierbei in Einheiten der Frequenz (Hertz, Hz) angegeben. Der Polarisationstransfer erfolgt hierbei nach einer Zeitdauer $\pi^2/A_x$, das bedeutet, dass die Sequenzdauer der Sequenz S vorzugsweise an diese Zeitdauer, beziehungsweise die Wechselwirkungsstärke $A_x$, angepasst ist.

Ein allgemeiner und schematisierter Aufbau der Sequenz S zur Erzeugung eines solchen effektiven Hamiltonians ist anhand der Blockdarstellung der Fig. 3 nachfolgend näher erläutert. In den Blockdarstellungen der Figuren 3 bis 7 sind die Hochfrequenzpulse als Rechtecke dargestellt, welche aufeinanderfolgend entlang einer nicht näher bezeichneten Zeitachse angeordnet sind.

Die (Polarisations-)Sequenz S umfasst eine Anzahl von Hochfrequenzpulsen, welche beispielsweise zu mehreren Sequenzabschnitten - in Fig. 3 beispielhaft mittels zweier Sequenzabschnitte $S_k$ und $S_{k'}$ dargestellt - zusammenfassbar sind. Die Sequenzabschnitte $S_k$ und $S_{k'}$ sind hierbei beispielsweise mittels optionaler Zwischenpulse $P_{inter}$ voneinander getrennt. Die Sequenz S ist von einem optionalen Initialisierungspuls $P_{init}$ und einem oder mehreren optionalen Endpulsen $P_{end}$ eingegriffen. Der Initialisierungspuls $P_{init}$ ist hierbei insbesondere ein Hochfrequenzpuls mit einem 90°-Flipwinkel, welcher einen Superpositionszustand des Elektronenspinmoments 16 erzeugt. Die Sequenz S ist zwischen dem Initalisierungspuls $P_{init}$ und dem optionalen Endpuls $P_{end}$ beispielsweise N-mal wiederholbar, wodurch der dadurch realisierte Polarisationstransfer verlängert wird.

Jeder Sequenzabschnitt $S_k$, $S_{k'}$ umfasst eine Anzahl $n_k$ beziehungsweise $n_{k'}$ von Hochfrequenzpulsen $P_{ki}$, $P_{k'i}$, welche auf die Elektronenspinmomente 16 für jeweils eine Pulsdauer $T^{pulse}_{ki}$, $T^{pulse}_{k'i}$ einwirken. Die Hochfrequenzpulse $P_{ki}$, $P_{k'i}$ sind hierbei gegeneinander mittels jeweils einer Zeitdauer (Pulspause, Evolutionszeit, Wartezeit) $T_{ki}$, $T_{k'i}$ zeitlich versetzt. Der Index i ist hierbei ein Laufindex welcher von 1 bis $n_k$ beziehungsweise $n_{k'}$ läuft. Hierbei ist es möglich, dass während der Sequenz S die einzelnen Sequenzabschnitte $S_k$ oder $S_{k'}$ jeweils mehrmals aufeinanderfolgend wiederholt werden.

Die Zeitdauern $T_{ki}$, $T_{k'i}$ und Pulsdauern $T^{pulse}_{ki}$, $T^{pulse}_{k'i}$ der Sequenzabschnitte $S_k$, $S_{k'}$ addieren sich hierbei zu einer Gesamtsequenzdauer T der Sequenz S, welche vorzugsweise geringer ist, als eine zu der Wechselwirkung W proportionale Polarisationstransferdauer. Mit anderen Worten ist die zum Bewirken des Polarisationstransfers notwendige Gesamtsequenzdauer T geringer als die Polarisationstransferdauer.

Jeder Sequenzabschnitt $S_k$, $S_{k'}$ weist mindestens eine Sequenzeinheit $E_{kj}$, $E_{k'j}$ mit einer jeweiligen Sequenzeinheitsdauer $T_{kj}$, $T_{k'j}$ auf. Mit anderen Worten ist ein Sequenzabschnitt $S_k$, $S_{k'}$ aus einem oder mehreren aufeinanderfolgenden Sequenzeinheiten $E_{kj}$, $E_{k'j}$ zusammengesetzt. Der Laufindex j nummeriert hierbei die Sequenzeinheiten $E_{kj}$, $E_{k'j}$ des Sequenzabschnitts $S_k$, $S_{k'}$. In der Fig. 3 ist jeder Sequenzabschnitt $S_k$, $S_{k'}$ beispielhaft mit lediglich einer Sequenzeinheit $E_{kj}$, $E_{k'j}$ dargestellt.

Die Sequenz S ist derart ausgestaltet, dass ein effektiver Hamiltonian der Form $S_x I_x + S_y I_y$ bewirkt wird. Zu diesem Zwecke sind die einzelnen Sequenzeinheiten $E_{kj}$, $E_{k'j}$ geeigneterweise so ausgebildet, dass während jeweils einer Sequenzeinheit $E_{kj}$, $E_{k'j}$ ein effektiver Hamiltonian der Form $S_x I_x$ oder $S_y I_y$ gebildet wird. Das bedeutet, dass mehrere Sequenzeinheiten $E_{kj}$, $E_{k'j}$ und/oder mehrere Sequenzabschnitte $S_k$, $S_{k'}$ notwendig sind, um die gewünschten Polarisationsdynamiken zu bewirken.

Für den Polarisationstransfer ist es daher notwendig, dass bei aufeinanderfolgenden Sequenzeinheiten $E_{kj}$, $E_{k'j}$ der Sequenz S effektiv die Spinoperatoren $S_x$ und $S_y$ sowie die Spinoperatoren $I_x$ und $I_y$ miteinander vertauscht werden.

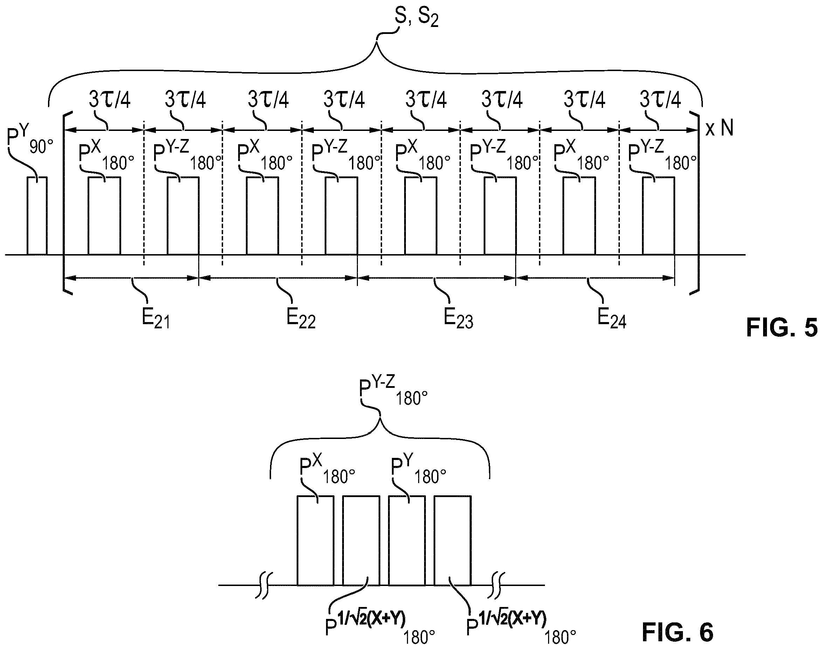

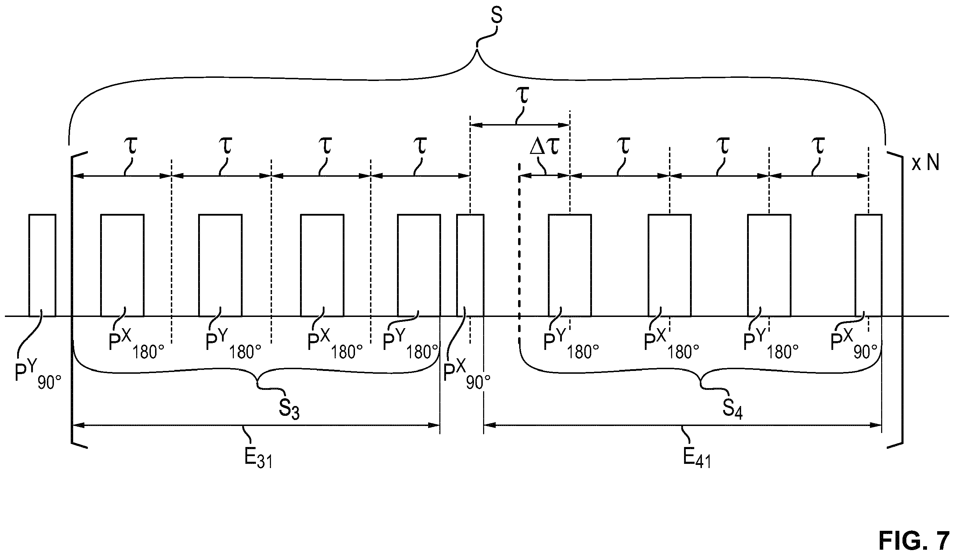

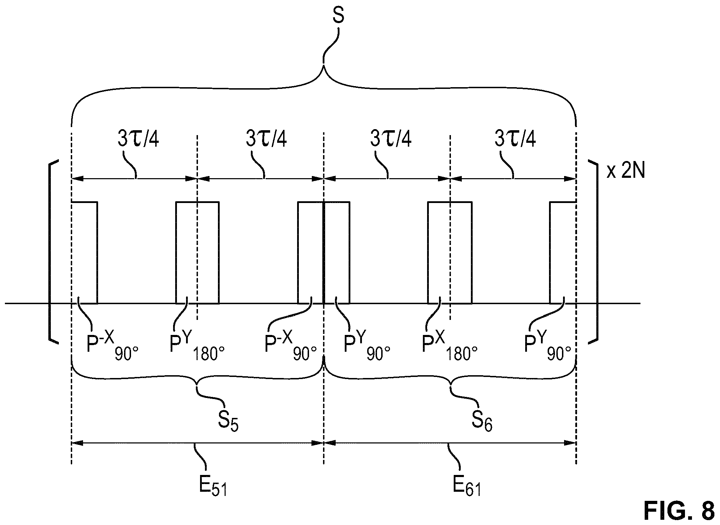

Für den Wechsel zwischen den Spinoperatoren $S_x$ und $S_y$ ist zwischen den Sequenzeinheiten $E_{kj}$, $E_{k'j}$ oder am Ende einer jeweiligen Sequenzeinheit $E_{kj}$, $E_{k'j}$ ein oder mehrere Hochfrequenzpulse vorgesehen. Hierbei ist es beispielsweise denkbar einen einzelnen Hochfrequenzpuls mit einem 90°-Flipwinkel (Fig. 4, Fig. 7) oder zwei unterschiedliche Hochfrequenzpulse mit einem 90°-Flipwinkel (Fig. 8) oder einen Hochfrequenzpuls mit einem 180°-Flipwinkel um eine Pulsachse $1/\sqrt{2}\,(X+Y)$ (Fig. 5) auszuführen. Wesentlich ist, dass durch den oder die Hochfrequenzpulse eine parallel zum Magnetfeld B orientierte Ausrichtung des zweiten Spinmoments 16 in eine senkrecht zum Magnetfeld B orientierte Ebene gedreht wird.

Der Wechsel zwischen den Spinoperatoren $I_x$ und $I_y$ wird vorzugsweise durch eine relative Phasenverschiebung zwischen den Spinoperatoren $S_x$ und $S_y$ bewirkt. Hierzu wird beispielsweise die Sequenzeinheitsdauer $T_{kj}$, $T_{k'j}$ auf ein ungeradzahliges Vielfaches einer halben Larmorperiode ($\pi/2\omega_{Larmor}$) der Spinmomente 10 im Magnetfeld B dimensioniert (Fig. 4, Fig. 5, Fig. 8). Ebenso denkbar ist es beispielsweise dass die Hochfrequenzpulse $P_{ki}$, $P_{k'i}$ aufeinanderfolgender Sequenzeinheiten $E_{kj}$, $E_{k'j}$ oder Sequenzabschnitte $S_k$, $S_{k'}$ einen relativen Zeitversatz $\Delta_T$ gegeneinander aufweisen, wobei der Zeitversatz geeigneterweise gleich einem ungeradzahligen Vielfachen der halben Larmorperiode der Spinmomente 10 im Magnetfeld B ist (Fig. 7).

Nachfolgend werden anhand der Figuren 4 bis 7 Ausführungsbeispiele der Sequenz S erläutert. Hierbei sind die Hochfrequenzpulse als $P^X_{90°}$, $P^Y_{90°}$, $P^X_{180°}$ oder $P^Y_{180°}$ bezeichnet, wobei die Winkelangabe den Flipwinkel beschreibt und X beziehungsweise Y die Pulsachse beziehungsweise Phasenlage des Hochfrequenzpulses in einem rotierenden Bezugsystem beschreibt. Ein $P^Y_{90°}$ Hochfrequenzpulse ist somit beispielsweise ein Hochfrequenzpuls mit einer Pulsdauer $T^{pulse}_{ki}$, $T^{pulse}_{k'i}$, welche bei einer gegebenen Pulsamplitude einen 90°-Flipwinkel des Elektronenspinmoments 16 bewirkt, und mit einem (relativen) 90°-Phasenversatz (Y) erzeugt wird.

In den Ausführungsbeispielen der Sequenzen S sind die Zeitdauern $T_{ki}$, $T_{k'i}$ zwischen den Hochfrequenzpulsen in Einheiten der halben Larmorperiode der Kernspinmomente 10 angegeben, das bedeutet mittels einer Zeitdauer $\tau = m2\pi/2\omega_{Larmor}$, wobei $\omega_{Larmor}$ die Larmorfrequenz der Kernspinmomente 10 im Magnetfeld B und m eine ungerade Zahl ist.

In der Fig. 4 ist ein erstes Ausführungsbeispiel der Sequenz S dargestellt. In dieser Ausführungsform umfasst die Sequenz S lediglich einen Sequenzabschnitt $S_1$ mit vier Sequenzeinheiten $E_{11}$, $E_{12}$, $E_{13}$ und $E_{14}$, welche jeweils einen Hochfrequenzpuls aufweisen. Der Initialisierungspuls $P^Y_{90°}$ ist hierbei als ein Hochfrequenzpuls mit einem 90°-Flipwinkel ausgeführt, welcher entlang einer Y-Pulsachse erzeugt wird. Die Hochfrequenzpulse der Sequenzeinheiten $E_{11}$, $E_{12}$, $E_{13}$ und $E_{14}$ sind hierbei jeweils als ein $P^X_{90°}$ Puls entlang einer X-Pulsachse und mit einem 90°-Flipwinkel ausgeführt. Die Hochfrequenzpulse $P^X_{90°}$ der Sequenz S beziehungsweise des Sequenzabschnitts $S_1$ sind hierbei jeweils mittels einer Zeitdauer $\tau/2 = 2\pi/4\omega_{Larmor}$ gegeneinander zeitlich versetzt.

Mit den vier aufeinanderfolgenden Sequenzeinheiten $E_{11}$, $E_{12}$, $E_{13}$ und $E_{14}$ wird effektiv zwischen den Spinoperatoren $S_x$ und $S_y$ des Elektronenspinmoments 16 gewechselt, sodass in einem rotierenden Bezugsystem ein effektiver Hamiltonian $H_{eff}$ mit der gewünschten Polarisationsdynamik erzeugt wird. Durch die Hochfrequenzpulsen $P^X_{90°}$ der Sequenzeinheiten $E_{11}$, $E_{12}$, $E_{13}$ und $E_{14}$ werden insbesondere vier Wechselwirkungsterme erzeugt. In der Zeitdauer vor dem ersten Hochfrequenzpuls $P^X_{90°}$ ist die Wechselwirkung W proportional zu dem Produkt $S_xI_x$ der Spinoperatoren $S_x$ und $I_x$. Zwischen dem ersten und dem zweiten Hochfrequenzpuls $P^X_{90°}$ ist die Wechselwirkung W proportional zu dem Produkt $S_yI_x$, da der Hochfrequenzpuls $P^X_{90°}$ effektiv den Spinoperatoren $S_x$ zu dem Spinoperatoren $S_y$ wechselt. Zwischen dem zweiten und dem dritten Hochfrequenzpuls $P^X_{90°}$ ist die Wechselwirkung W charakterisiert durch das Produkt $-S_xI_x$, wobei die Wechselwirkung W entsprechend nach dem vierten $P^X_{90°}$ Hochfrequenzpuls als $-S_yI_x$ beschreibbar ist. Dadurch wird in einem rotierenden Bezugssystem die durch den effektiven Hamiltonian $H_{eff}$ charakterisierte Spindynamik für den Polarisationstransfer erzeugt.

Anhand der Fig. 5 und der Fig. 6 wird nachfolgend ein zweites Ausführungsbeispiel der Sequenz S beschrieben. In dieser Ausgestaltung weist die Sequenz S einen Sequenzabschnitt $S_2$ mit vier Hochfrequenzpulsen $P^X_{180°}$ und mit vier Composite-Pulsen $P^{Y-Z}_{180°}$ auf, welche abwechselnd oder alternierend auf das Elektronenspinmoment 16 einwirken. Die Hochfrequenzpulse $P^X_{180°}$ und die Composite-Pulsen $P^{Y-Z}_{180°}$ sind hierbei jeweils mittels gleichen Zeitdauern $3\tau/4 = 6\pi/8\omega_{Larmor}$ gegeneinander zeitlich versetzt. Grundsätzlich ist es hierbei möglich die Zeitdauer $m\tau/4$ zu verwenden, wobei m eine ungerade Zahl ist. Mit anderen Worten sind die Zeitdauern $\tau_{ki}$, $\tau_{k'i}$ zwischen den Pulsen $P^X_{180°}$ und $P^{Y-Z}_{180°}$ länger als in dem Sequenzabschnitt $S_1$ des vorstehend beschriebenen Ausführungsbeispiels. Der Sequenzabschnitt $S_2$ ist hierbei aus vier gleichartigen Sequenzeinheiten $E_{21}$, $E_{22}$, $E_{23}$ und $E_{24}$ zusammengesetzt, welche jeweils einen Hochfrequenzpuls $P^X_{180°}$ und einen Composite-Puls $P^{Y-Z}_{180°}$ umfassen.

Die Fig. 6 zeigt schematisch den Aufbau eines (Y-Z-)Composite-Pulses $P^{Y-Z}_{180°}$. Der Composite-Pulse $P^{Y-Z}_{180°}$ umfasst vier unmittelbar aufeinanderfolgende Hochfrequenzpulse, welche zusammengesetzt den 180°-Flipwinkel um eine Y-Z-Pulsachse umsetzen. Der erste Hochfrequenzpuls $P^X_{180°}$ weist einen 180°-Flipwinkel um die X-Pulsachse auf.

Der darauffolgende Hochfrequenzpuls $P^{1/\sqrt{2}\,(X+Y)}_{180°}$ führt einen 180°-Flipwinkel um eine Pulsachse $1/\sqrt{2}\ (X+Y)$, welche winkelhalbierend zwischen der X- und der Y-Pulsachse angeordnet ist, aus. Mit anderen Worten weist der Hochfrequenzpuls $P^{1/\sqrt{2}\,(X+Y)}_{180°}$ jeweils einen relativen Phasenversatz von 45° gegenüber der X-Pulsachse (0°) und der Y-Pulsachse (90°) auf. Der dritte Hochfrequenzpuls $P^Y_{180°}$ führt einen 180°-Flipwinkel um die Y-Pulsachse aus, wobei das Einwirken des vierten Hochfrequenzpulses $P^{1/\sqrt{2}\,(X+Y)}_{180°}$ einen 180°-Flipwinkel um die winkelhalbierende Pulsachse $1/\sqrt{2}\ (X+Y)$.

Das Ausführungsbeispiel der Figur 7 zeigt eine Sequenz S mit zwei Sequenzabschnitten $S_3$ und $S_4$, welche mittels eines Hochfrequenzpulses $P^X_{90°}$ (Zwischenpuls) voneinander getrennt sind. Die Sequenzabschnitte $S_3$ und $S_4$ umfassen hierbei jeweils lediglich eine Sequenzeinheit $E_{31}$ beziehungsweise $E_{41}$.

Der Sequenzabschnitt $S_3$ ist hierbei vorzugsweise nach Art einer XY-Entkopplungssequenz, insbesondere einer XY4-Entkopplungssequenz ausgeführt. Dies bedeutet, dass der Sequenzabschnitt $S_3$ im Wesentlichen vier Hochfrequenzpulse $P^X_{180°}$, $P^Y_{180°}$, $P^X_{180°}$ und $P^Y_{180°}$ umfasst, welche jeweils einen 180°-Flipwinkel aufweisen und alternierend entlang der X-Pulsachse und der Y-Pulsachse erzeugt werden. Die vier Hochfrequenzpulse $P^X_{180°}$, $P^Y_{180°}$, $P^X_{180°}$ und $P^Y_{180°}$ des Sequenzabschnitts $S_3$ sind jeweils mittels einer Zeitdauer $\tau = 2\pi/2\omega_{Larmor}$ gegeneinander zeitlich versetzt.

Der Sequenzabschnitt $S_4$ weist in diesem Ausführungsbeispiel vier Hochfrequenzpulse $P^Y_{180°}$, $P^X_{180°}$, $P^Y_{180°}$ und $P^X_{90°}$ auf, welche gegeneinander mittels der Zeitdauer $\tau$ versetzt sind. Der Sequenzabschnitt $S_4$ ist hierbei im

Wesentlichen spiegelsymmetrisch zu dem Sequenzabschnitt $S_3$ bezüglich des Zwischenpulses $P^X_{90°}$ ausgeführt, wobei der letzte Hochfrequenzpuls $P^X_{90°}$ des Sequenzabschnittes $S_3$ einen 90°-Flipwinkel aufweist. Wie in der Fig. 7 vergleichsweise deutlich ersichtlich ist weist der Sequenzabschnitt $S_4$ zusätzlich einen Zeitversatz $\Delta\tau$ gegenüber dem Sequenzabschnitt $S_3$ auf.

Der Zwischenpuls $P^X_{90.}$ zwischen den Sequenzabschnitten $S_3$ und $S_4$ weist einen 90°-Phasenversatz gegenüber dem Initialisierungspuls $P^Y_{90°}$ auf. Die Pulsachse beziehungsweise die Phasenlage des Zwischenpulses $P^X_{90°}$ ist hierbei gleich der Phasenlage des letzten Hochfrequenzpulses $P^X_{90°}$ des Sequenzabschnitts $S_4$. Der letzte Hochfrequenzpuls $P^Y1_{80°}$ des Sequenzabschnittes $S_3$ weist einen Pulsabstand von $\tau/2$ gegenüber dem Zwischenpuls $P^X_{90°}$ auf, wobei der Pulsabstand zwischen dem Zwischenpuls $P^X_{90°}$ und dem ersten Hochfrequenzpuls $P^Y_{180°}$ des Sequenzabschnitts $S_4$ aufgrund des Zeitversatzes $\Delta\tau$ im Wesentlichen $\Delta\tau + \tau/2$ beträgt. Der Zeitversatz $\Delta\tau$ ist hierbei insbesondere $\Delta\tau = \tau/2$, sodass der Pulsabstand zwischen dem Zwischenpuls $P^X_{90°}$ und dem ersten Hochfrequenzpuls $P^Y_{180°}$ des Sequenzabschnitts $S_4$ gleich der Zeitdauer $\tau$ ist.

Der Sequenzabschnitt $S_3$ erzeugt hierbei im Wesentlichen eine Spindynamik welche proportional zu einem Faktor $\cos(\omega t)S_x I_x$ ist, wobei $\omega$ die Frequenz der Hochfrequenzstrahlung der Hochfrequenzpulse ist. Durch den Zeitversatz $\Delta\tau$ wird entsprechend während des Sequenzabschnitts $S_4$ eine zu $\sin(\omega t)S_y I_x$ proportionale Spindynamik erzeugt. In einem mit der Frequenz $\omega$ rotierenden Bezugssystem wird hierdurch der effektive Hamiltonian $H_{eff}$ für den Polarisationstransfer erzeugt.

Die Sequenz S der Fig. 7 ermöglicht den Einsatz von starken Hochfrequenzpulsen, das bedeutet die Hochfrequenzpulse weisen vorzugsweise eine hohe Pulsamplitude und eine vergleichsweise kurze Pulsdauer $\tau^{pulse}_{ki}$, $\tau^{pulse}_{k'i}$ auf. Unter einer kurzen Pulsdauer $\tau^{pulse}_{ki}$, $\tau^{pulse}_{k'i}$ ist insbesondere eine Zeitdauer des Hochfrequenzpulses zu verstehen, welche vergleichsweise kurz gegenüber der zugeordneten Zeitdauer $\tau_{ki}$, $\tau_{k'i}$ ist. Vorzugsweise ist die Pulsdauer $\tau^{pulse}_{ki}$, $\tau^{pulse}_{k'i}$ kleiner als $\tau_{ki}/5$ beziehungsweise $\tau_{k'i}/5$.

In der Fig. 8 ist ein weiteres Ausführungsbeispiel der Sequenz S mit zwei Sequenzabschnitten $S_5$ und $S_6$ dargestellt. Die Sequenzabschnitte $S_5$ und $S_6$ weisen jeweils eine Sequenzeinheit $E_{51}$ und $E_{61}$ auf.

Der erste Sequenzabschnitt $S_5$ weist hierbei drei aufeinanderfolgende Hochfrequenzpulse $P^{-X}_{90°}$, $P^Y_{180°}$ und $P^{-X}_{90°}$ auf, welche gegeneinander mittels einer Zeitdauer $3\tau/4 = 6\pi/8\omega_{Larmor}$ versetzt sind. Beispielsweise ist es hierbei auch möglich die Zeitdauer $m\tau/4$ zu verwenden, wobei m eine ungerade Zahl ist. Der erste und dritte Hochfrequenzpuls $P^{-X}_{90°}$ weist jeweils einen 90°-Flipwinkel entlang der -X-Pulsachse, das bedeutet entlang der negativen X-Pulsachse, auf. Der dazwischen eingefasste zweite Hochfrequenzpuls $P^Y_{180°}$ weist einen 180°-Flipwinkel entlang der Y-Pulsachse auf.

Der zweite Sequenzabschnitt $S_6$ weist einen im Wesentlichen identischen Aufbau zum ersten Sequenzabschnitt $S_5$ auf, wobei die Pulsachsen im Vergleich zum ersten Sequenzabschnitt $S_5$ verändert sind. Während des zweiten Sequenzabschnitts $S_6$ werden hierbei drei aufeinanderfolgende Hochfrequenzpulse $P^Y_{90°}$, $P^X_{180°}$ und $P^Y_{90°}$ erzeugt, welche gegeneinander mittels einer Zeitdauer $3\tau/4 = 6\pi/8\omega_{Larmor}$ versetzt sind. Der erste und dritte Hochfrequenzpuls $P^Y_{90°}$ weist somit jeweils einen 90°-Flipwinkel entlang der Y-Pulsachse auf. Der dazwischen eingefasste zweite Hochfrequenzpuls $P^X_{180°}$ weist entsprechend einen 180°-Flipwinkel entlang der X-Pulsachse auf, das bedeutet entlang der inversen Pulsrichtung zu den ersten und dritten Hochfrequenzpulsen $P^{-X}_{90°}$ des Sequenzabschnitts $S_5$. Der erste Hochfrequenzpuls $P^Y_{90°}$ des Sequenzabschnitts $S_6$ schließt sich hierbei während der Sequenz S unmittelbar an den dritten Hochfrequenzpuls $P^{-X}_{90°}$ des Sequenzabschnitts $S_5$ an.

In dieser Ausführung der Sequenz S sind vorteilhafterweise keine zusätzlichen Initialisierungspulse $P_{init}$ und/oder Endpulse $P_{end}$ notwendig, wodurch eine besonders einfache Sequenz S realisiert ist. Des Weiteren sind die Pulsabstände beziehungsweise die Zeitdauern $3\tau/4$ vorzugsweise derart dimensioniert, dass die endliche Pulsdauer $\tau^{pulse}_{ki}$, $\tau^{pulse}_{k'i}$ der Hochfrequenzpulse $P^{-X}_{90°}$, $P^Y_{180°}$, $P^Y_{90°}$, $P^X_{180°}$ berücksichtigt wird. Die Sequenz S weist in dieser Ausführungsform bei einer Wiederholung vorzugsweise eine geradzahlige Anzahl 2N von Wiederholungen auf.

Des Weiteren ist die Sequenz S in dieser Ausgestaltungsform insbesondere robust gegenüber Frequenzverstimmungen, das bedeutet gegenüber Abweichungen der Frequenz $\omega$ von der Larmorfrequenz des Elektronenspinmoments 16 im Magnetfeld B. Weiterhin weist die Sequenz S eine hohe Effektivität hinsichtlich des Polarisationstransfers auch bei Pulsfehlern, das bedeutet bei einer abweichenden Phasenlage oder Phasendauer, der Hochfrequenzpulse auf.

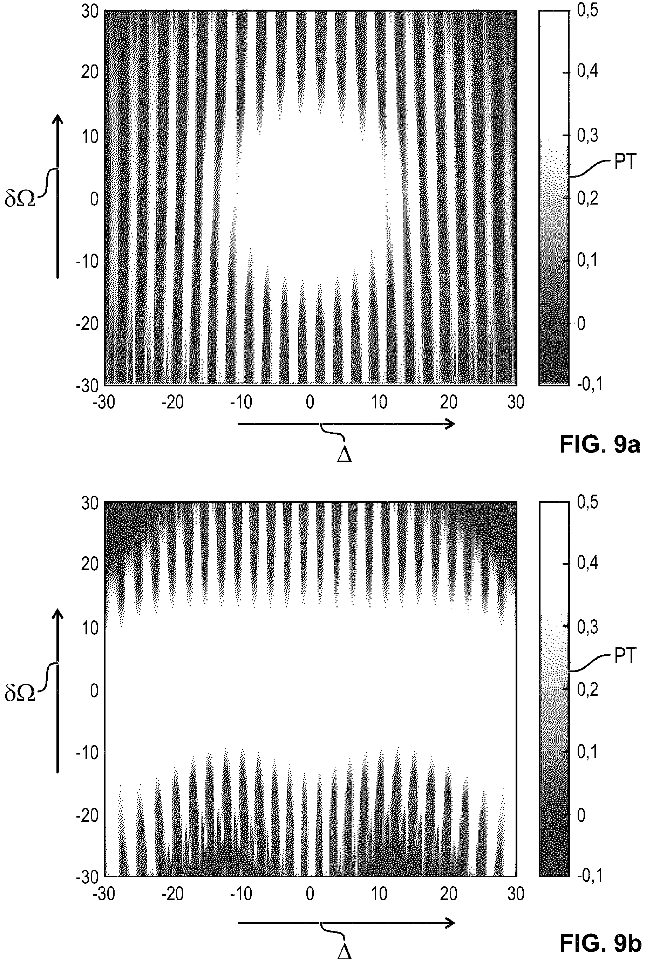

In den Figuren 9a und 9b ist jeweils eine zweidimensionale Darstellung einer Simulation als Beispiel für die verbesserte Stabilität und Robustheit der Sequenz S gemäß der Fig. 8 gezeigt. Die Simulationen der Figuren 9a und 9b betreffen ein System aus fünf Kernspinmomenten 10 und einem Elektronenspinmoment 16, wobei die Wechselwirkungsstärken W gaußverteilt sind.

Die Simulationen zeigen hierbei den Effekt von Pulsfehlern $\delta\Omega$ und (Frequenz)Verstimmungen $\Delta$ auf den Polarisationstransfer PT. Entlang der Ordinatenachse (y-Achse) ist der Pulsfehler $\delta\Omega$ und entlang der Abszissenachse (x-Achse) die Verstimmung $\Delta$ aufgetragen, wobei die Grauskala den jeweiligen Wert des Polarisationstransfers PT darstellt. Der Pulsfehler $\delta\Omega$ ist hierbei als prozentuale Abweichung einer Pulsamplitude $\Omega$ von einer fehlerfreien Pulsamplitude $\Omega_0$ definiert. Unter der Verstimmung $\Delta$ wird hierbei eine Abweichung der Frequenz $\omega$ der Hochfrequenzpulse von der Larmorfrequenz $\omega_e$ des Elektronenspinmoments 16 im Magnetfeld B verstanden, wobei die Verstimmung $\Delta$ in Einheiten

von Megahertz (MHz) aufgetragen ist. Der Polarisationstransfer PT ist definiert als

$$\sum_i \langle I_z^i(t) \rangle - \langle I_z^i(0) \rangle,$$

das bedeutet als eine Summe der Differenzen zwischen den Erwartungswerten der z-Komponenten der Spinoperatoren der Kernspinmomente 10 zum Anfang und Ende der Sequenz S.

Die simulierten Dynamiken während eines Hochfrequenzpulses sind in einem mit der Frequenz $\omega$ rotierenden Bezugssystem als

$$U_{\theta,\pm X/\pm Y} = \exp\left[-i\frac{\theta}{\Omega_0}\left(\Delta S_z \pm \Omega S_{X/Y} + \sum_j \omega_I I_z^j + S_z\left(A_x^j I_x^j + A_z^j I_z^j\right)\right)\right]$$

beschrieben, wobei $U_{\theta,\pm X/\pm Y}$ den Effekt eines Pulses $P_\theta^{\pm X/\pm Y}$ beschreibt, also einer Drehung um den Winkel $\theta$ entlang einer Pulsachse $\pm X$ oder $\pm Y$. $A_x^j$ und $A_z^j$ beschreiben die senkrechte und die parallele Komponente der Wechselwirkung (in MHz) zwischen dem Elektronenspinmoment 16 (Spinoperator $S_z$) und dem j-ten Kernspinmoment 10 (I). Für die dargestellten Simulationen werden eine Larmorfrequenz $\omega_I$ = 2 MHz für die Kernspinmomente 10 und $\Omega_0$ = 50 MHz für die fehlerfreie Pulsamplitude als Simulationsparameter verwendet.

In der in Fig. 9a dargestellten Simulation ist das Ergebnis für die Sequenz S der Fig. 8 mit rechteckförmigen Pulsen $P_{90°}^{-X}$, $P_{180°}^{Y}$, $P_{90°}^{Y}$, $P_{180°}^{X}$ für das System aus fünf Kernspinmomenten 10 und dem Elektronenspinmoment 16 gezeigt. Die Simulation der Fig. 9b zeigt das Ergebnis die Sequenz S der Fig. 8 für das gleiche System, wobei die Hochfrequenzpulse als Composite-Pulse mit symmetrischen Phasen ausgeführt sind, welche durch die Evolutionen

$$U_{90°,\pm X/\pm Y} = U_{-16°,\pm X/\pm Y}\, U_{300°,\pm X/\pm Y}\, U_{-266°,\pm X/\pm Y}\, U_{54°,\pm X/\pm Y}\, U_{-266°,\pm X/\pm Y}\, U_{300°,\pm X/\pm Y}\, U_{-16°,\pm X/\pm Y}$$

und

$$U_{180°,\pm X/\pm Y} = U_{325°,\pm X/\pm Y}\, U_{-263°,\pm X/\pm Y}\, U_{56°,\pm X/\pm Y}\, U_{-263°,\pm X/\pm Y}\, U_{325°,\pm X/\pm Y}$$

beschrieben sind. Aufgrund der längeren Pulsdauern der Composite-Pulse ist für die in Fig. 9b simulierte Sequenz S die Zeitdauer zwischen den Composite-Pulsen auf $5\tau/4 = 10\pi/8\omega_{Larmor}$ erhöht.

Die Erfindung ist nicht auf die vorstehend beschriebenen Ausführungsbeispiele beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit den Ausführungsbeispielen beschriebenen Einzelmerkmale auch auf andere Weise miteinander kombinierbar, ohne den Gegenstand der Erfindung zu verlassen.

Wesentlich ist, dass durch die Sequenz S das Elektronenspinmoment 16 derart manipuliert wird, dass ein Polarisationstransfer von dem Elektronenspinmoment 16 auf ein wechselwirkendes Kernspinmoment 10 ermöglicht wird. Dadurch erfolgt der Polarisationstransfer nicht während eines Hochfrequenzpulses $P_{ki}$, $P_{k'i}$, sondern insbesondere aufgrund der Summe der einzelnen Spindynamiken während den Zeitdauern $\tau_{ki}$, $\tau_{k'i}$ zwischen den Hochfrequenzpulsen $P_{ki}$, $P_{k'i}$. Dadurch wird ein Polarisationstransfer unabhängig von der Hartmann-Hahn-Bedingung ermöglicht. Dies überträgt sich in der Folge vorteilhaft auf die Flexibilität, insbesondere werden hierdurch die technischen Anforderungen an die Stabilität und Qualität des Hochfrequenzgenerators 26 reduziert.

In einer denkbaren Alternativform sind die ersten Kernspinmomente 10 und Elektronenspinmomente 16 Teil einer gemeinsamen Molekülstruktur eines Moleküls oder einer gemeinsamen Gitterstruktur eines Festkörpers als Materialprobe 4. Die Materialprobe 4 kann hierbei auch eine biologische oder medizinische Probe wie beispielsweise eine Zelle sein. Ebenso denkbar ist eine Ausführung, bei welcher das Elektronenspinmoment 16 Teil eines freien Mono- oder Biradikalmoleküls oder eines metallischen Ions oder eines photoanregbaren Triplet-Zustand-Moleküls ist. Wesentlich ist, dass das Elektronenspinmoment 16 in Wechselwirkung mit den Kernspinmomenten 10 gebracht wird. Geeigneterweise ist das Elektronenspinmoment 16 optisch polarisierbar.

In einer weiteren alternativen Ausgestaltungsform ist es beispielsweise möglich, dass zusätzlich zu der auf die Elektronenspinmomente 16 einwirkenden Sequenz S ein oder mehrere Hochfrequenzpulse auf die Kernspinmomente 10 eingewirkt werden, welche eine Frequenz aufweisen, welche resonant mit der Larmorfrequenz $\omega_{Larmor}$ der Kernspinmomente 10 im Magnetfeld B ist.

Bezugszeichenliste

| | |
|---|---|
| 2 | Vorrichtung |
| 4 | Materialprobe |
| 6 | Magnet |
| 6a | Nordpol |
| 6b | Südpol |
| 8 | Probenbehälter |
| 10 | Spinmoment/Kernspinmoment |
| 12 | Festkörperprobe/Nanopartikel/Nanodiamant |
| 14 | Farbzentrum |
| 16 | Spinmoment/Elektronenspinmoment |
| 18 | Laserlicht |
| 20 | Laser |
| 22 | Anregungsspule |
| 24 | Detektionsspule |
| 26 | Hochfrequenzgenerator |
| 28 | Receiver |
| 30 | Anzeigegerät |
| 32 | NMR-Spektrum |

| | |
|---|---|
| $B$ | Magnetfeld |
| $S$ | Sequenz/Polarisationssequenz |
| $D$ | NMR-Signal |
| $M_z$ | Gleichgewichtsmagnetisierung |
| $M_z'$ | Magnetisierung |
| $M_{xy}$ | Transversalmagnetisierung |
| $W$ | Wechselwirkung |
| $H_{eff}$ | Hamiltonian |
| $A_x$ | Wechselwirkungsstärke |
| $\pi$ | Kreiszahl |
| $\omega$ | Frequenz |
| $\omega_{Larmor}$, $\omega_e$, $\omega_I$ | Larmorfrequenz |
| $I_x$, $I_y$, $I_+$, $I_-$ | Spinoperator |
| $S_x$, $S_y$, $S_z$, $S_+$, $S_-$ | Spinoperator |
| $S_k$, $S_{k'}$ | Sequenzabschnitt |
| $S_1$, $S_2$, $S_3$, $S_4$, $S_5$, $S_6$ | Sequenzabschnitt |
| $P_{inter}$ | Zwischenpuls |
| $P_{ki}$, $P_{k'i}$ | Hochfrequenzpuls |
| $PX_{90°}$, $PY_{90°}$. $PX_{180°}$, $PY1_{80"}$, $P^{1/\sqrt{2}\,(X+Y)}_{108°}$ | Hochfrequenzpuls |
| $\tau^{Pulse}_{ki}$, $\tau^{pulse}_{k'i}$ | Pulsdauer |
| $\tau_{ki}$, $\tau_{k'i}$, $\tau$ | Zeitdauern |
| $E_{kj}$, $E_{k'j}$ | Sequenzeinheit |
| $T_{kj}$, $T_{k'j}$ | Sequenzeinheitsdauer |
| $T$ | Gesamtsequenzdauer |
| $\Delta\tau$ | Zeitversatz |
| $n_k$, $n_{k'}$ | Pulsanzahl |
| $P_{init}$ | Initialisierungspuls |
| $P_{end}$ | Endpuls |
| $PY\text{-}Z_{180°}$ | Composite-Puls |

X, Y, $1/\sqrt{2}$ (X+Y)  Pulsachse
$U_{\theta, \pm X/\pm Y}$  Operator
$\delta\Omega$  Pulsfehler
$\Omega, \Omega_0$  Pulsamplitude
$\Delta$  Verstimmung
PT  Polarisationstransfer

## Patentansprüche

1. Verfahren zur Hyperpolarisierung einer Materialprobe (4), welche eine Anzahl von ersten Spinmomenten (10) einer ersten Spinmomentsorte aufweist,

   - wobei die Anzahl von ersten Spinmomenten (10) in Wechselwirkung mit einem zweiten Spinmoment (16) einer zweiten Spinmomentsorte gebracht wird,
   - wobei die ersten Spinmomente (10) Kernspinmomente sind und das zweite Spinmoment (16) ein Elektronenspinmoment ist,
   - wobei die ersten und zweiten Spinmomente (10, 16) einem homogenen Magnetfeld (B) ausgesetzt werden,
   - wobei das zweite Spinmoment (16) entlang des Magnetfelds (B) optisch polarisiert wird,
   - wobei das zweite Spinmoment (16) kohärent mittels einer Sequenz (S) mit einer Anzahl von aufeinanderfolgenden Hochfrequenzpulsen ($P_{ki}$, $P_{k'i}$), die durch Pulspausen zwischen den Hochfrequenzpulsen ($P_{ki}$, $P_{k'i}$) zeitlich gegeneinander versetzt sind, wobei die Dauer der Pulspausen von der Larmorfrequenz der ersten Spinmomente im Magnetfeld (B) abhängt, derart manipuliert wird, dass als Effekt einer Evolution des zweiten Spinmoments am Ende der Sequenz ein Flip-Flop Prozess und folglich ein Polarisationstransfer von dem zweiten Spinmoment (16) auf die ersten Spinmomente (10) erfolgt.

2. Verfahren nach Anspruch 1, **dadurch gekennzeichnet,**
   **dass** für jeden Hochfrequenzpuls der Sequenz (S) lediglich ein Flipwinkel von 90° und/oder 180° eingesetzt wird.

3. Verfahren nach einem der Ansprüche 1 bis 2, **dadurch gekennzeichnet, dass** die Hochfrequenzpulse entlang zweier zueinander senkrecht orientierten Pulsachsen erzeugt werden.

4. Verfahren nach einem der Ansprüche 1 bis 3, **dadurch gekennzeichnet, dass** ein Hochfrequenzpuls ($P_{ki}$, $P_{k'i}$) der Sequenz (S) ein Composite-Puls ist, bei welchem mehrere einzelne Hochfrequenzpulse entlang unterschiedlicher Pulsachsen ohne eine dazwischen eingebrachte Pulspause aneinandergereiht werden, sodass bei einem Einwirken des Composite-Pulses ein effektiver Flipwinkel ausgeführt wird.

5. Verfahren nach einem der Ansprüche 1 bis 4, **dadurch gekennzeichnet, dass** als zweites Spinmoment (16) ein Elektronenspinmoment eines Farbzentrums (14) einer Festkörperprobe (12) verwendet wird.

6. Verfahren nach einem der Ansprüche 1 bis 5, **dadurch gekennzeichnet, dass** während der Sequenz (S) ein Sequenzabschnitt ($S_2$) erzeugt wird, bei welchem vier mittels gleicher Zeitdauern von Pulspausen zwischen den Hochfrequenzpulsen gegeneinander versetzte Hochfrequenzpulse mit jeweils einem 90°-Flipwinkel aufeinanderfolgen.

7. Verfahren nach einem der Ansprüche 1 bis 6, **dadurch gekennzeichnet, dass** während der Sequenz (S) ein Sequenzabschnitt ($S_2$) erzeugt wird, bei welchem eine Anzahl von mittels gleicher Zeitdauern von Pulspausen zwischen den Hochfrequenzpulsen gegeneinander versetzten Hochfrequenzpulsen mit jeweils einem 180°-Flipwinkel aufeinanderfolgen, wobei die Hochfrequenzpulse abwechselnd als Composite-Pulse , bei welchen mehrere einzelne Hochfrequenzpulse entlang unterschiedlicher Pulsachsen ohne eine dazwischen eingebrachte Pulspause aneinandergereiht werden, sodass bei einem Einwirken des Composite-Pulses ein effektiver Flipwinkel ausgeführt wird, ausgebildet sind.

8. Verfahren nach einem der Ansprüche 1 bis 7, **dadurch gekennzeichnet, dass** während der Sequenz (S) aufeinanderfolgend ein erster Sequenzabschnitt ($S_3$) und ein Hochfrequenzpuls mit 90°-Flipwinkel sowie ein zweiter Sequenzabschnitt ($S_4$) erzeugt werden, wobei während der Sequenzabschnitte ($S_3$, $S_4$) jeweils eine Anzahl von mittels

gleicher Zeitdauern ($\tau$) gegeneinander versetzte Hochfrequenzpulsen mit jeweils einem 180°-Flipwinkel aufeinanderfolgen, und wobei die Zeitdauern ($\tau$) des zweiten Sequenzabschnitts ($S_4$) einen relativen Zeitversatz ($\Delta\tau$) zu den Zeitdauern (1) des ersten Sequenzabschnitts ($S_3$) aufweisen.

9. Verfahren nach einem der Ansprüche 1 bis 8, **dadurch gekennzeichnet, dass** während der Sequenz (S) unmittelbar aufeinanderfolgend ein erster Sequenzabschnitt ($S_5$) und ein zweiter Sequenzabschnitt ($S_6$) erzeugt werden, wobei die Sequenzabschnitte ($S_5$, $S_6$) jeweils zwei Hochfrequenzpulse mit einem 90°-Flipwinkel umfassen, zwischen denen mittig jeweils ein Hochfrequenzpuls mit einem 180°-Flipwinkel angeordnet ist, wobei im ersten Sequenzabschnitt ($S_5$) die Hochfrequenzpulse mit einem 90°-Flipwinkel entlang einer ersten Pulsachse und der Hochfrequenzpuls mit einem 180°-Flipwinkel entlang einer senkrecht zur ersten Pulsachse orientierten zweiten Pulsachse erzeugt werden, und wobei im zweiten Sequenzabschnitt ($S_6$) die Hochfrequenzpulse mit einem 90°-Flipwinkel entlang der zweiten Pulsachse und der Hochfrequenzpuls mit einem 180°-Flipwinkel entlang der negativen ersten Pulsachse erzeugt werden

10. Verfahren nach einem der Ansprüche 8 oder 9, **dadurch gekennzeichnet, dass** der oder die Sequenzabschnitte ($S_1$, $S_2$, $S_3$, $S_4$, $S_5$, $S_6$) während der Sequenz (S) mehrmals aufeinanderfolgend wiederholt werden.

11. Vorrichtung (2) eingerichtet zur Hyperpolarisierung einer Materialprobe (4) vor und/oder während einer Magnetresonanz-Analyse gemäß dem Verfahren nach einem der Ansprüche 1 bis 10.

**Claims**

1. A method for hyperpolarizing a sample of material (4) having several first spin moments (10) of a first spin moment type,

   - wherein the number of first spin moments (10) is brought into interaction with a second spin moment (16) of a second spin moment type,
   - wherein the first spin moments (10) are nuclear spin moments, and the second spin moment (16) is an electron spin moment,
   - wherein the first and second spin moments (10, 16) are subjected to a homogeneous magnetic field (B),
   - wherein the second spin moment (16) is optically polarized along the magnetic field (B),
   - wherein the second spin moment (16) is coherently manipulated by means of a sequence (S) comprising a number of successive high frequency pulses ($P_{ki}$, $P_{k'i}$) offset in time from each other by pulse pauses between the high frequency pulses ($P_{ki}$, $P_{k'i}$), the duration of the pulse pauses being dependent on the Larmor frequency of the first spin moments in the magnetic field (B), in such a way that, as an effect of an evolution of the second spin moment at the end of the sequence, a flip-flop process and consequently a polarization transfer from the second spin moment (16) to the first spin moments (10) takes place.

2. The method according to claim 1, **characterized in that** only one flip angle of 90° and/or 180° is used for each high-frequency pulse of the sequence (S).

3. The method according to any one of claims 1 to 2, **characterized in that** the high-frequency pulses are generated along two mutually perpendicularly oriented pulse axes.

4. The method according to any one of claims 1 to 3, **characterized in that** a high-frequency pulse ($P_{ki}$, $P_{k'i}$) of the sequence(S) is a composite pulse in which a plurality of individual high-frequency pulses is lined up along different pulse axes without an intervening pulse pause so that an effective flip angle is performed when the composite pulse is applied.

5. The method according to any one of claims 1 to 4, **characterized in that** an electron spin moment of a colour centre (14) of a solid sample (12) is used as a second spin moment (16).

6. The method according to any one of claims 1 to 5, **characterized in that** during the sequence (S) a sequence section ($S_2$) is generated in which four high-frequency pulses, offset from one another by means of equal time durations of pulse pauses between the high-frequency pulses, each with a 90° flip angle, follow one another.

7. The method according to any one of claims 1 to 6, **characterized in that** during the sequence (S) a sequence

section ($S_2$) is generated in which a number of high-frequency pulses offset from one another by means of equal time durations of pulse pauses between the high-frequency pulses follow one another with a 180° flip angle in each case, wherein the high-frequency pulses are alternately formed as composite pulses, in which a plurality of individual high-frequency pulses are lined up along different pulse axes without an intervening pulse pause, so that an effective flip angle is executed when the composite pulse is applied.

8. The method according to any one of claims 1 to 7, **characterized in that** during the sequence (S) a first sequence section ($S_3$) and a high-frequency pulse with a 90° flip angle as well as a second sequence section ($S_4$) are successively generated, wherein during the sequence sections ($S_3$, $S_4$) in each case a number of pulses generated by means of equal time durations (T) follow one another with a 180° flip angle in each case, and wherein the time durations (T) of the second sequence section ($S_4$) have a relative time offset ($\Delta\tau$) to the time durations (1) of the first sequence segment ($S_3$).

9. The method according to any one of claims 1 to 8, **characterized in that** during the sequence (S) a first sequence section ($S_5$) and a second sequence section ($S_6$) are generated in immediate succession, the sequence sections ($S_5$, $S_6$) each comprising two high-frequency pulses with a 90 flip angle, between which in each case a high-frequency pulse with a 180° flip angle is arranged centrally, wherein in the first sequence section ($S_5$) the high-frequency pulses with a 90° flip angle along a first pulse axis and the high-frequency pulse with a 180° flip angle along a second pulse axis oriented perpendicular to the first pulse axis are generated, and wherein in the second sequence section ($S_6$) the high-frequency pulses with a 90° flip angle are generated along the second pulse axis and the high-frequency pulse with a 180° flip angle is generated along the negative first pulse axis.

10. The method according to any one of claims 8 or 9, **characterized in that** the sequence section or sections ($S_1$, $S_2$, $S_3$, $S_4$, $S_5$, $S_6$) are repeated several times in succession during the sequence (S).

11. A device (2) configured to hyperpolarize a material sample (4) before and/or during a magnetic resonance analysis according to the method of any one of claims 1 to 10.

## Revendications

1. Procédé d'hyperpolarisation d'un échantillon de matériau (4) présentant plusieurs premiers moments de spin (10) d'un premier type de moment de spin

   - dans lequel le nombre de premiers moments de spin (10) est mis en interaction avec un deuxième moment de spin (16) d'un deuxième type de moment de spin,
   - dans lequel les premiers moments de spin (10) sont des moments de spin nucléaire, et le second moment de spin (16) est un moment de spin électronique,
   - dans lequel les premier et deuxième moments de spin (10, 16) sont soumis à un champ magnétique homogène (B),
   - dans lequel le deuxième moment de spin (16) est optiquement polarisé le long du champ magnétique (B),
   - dans lequel le deuxième moment de spin (16) est manipulé de manière cohérente au moyen d'une séquence (S) comprenant un certain nombre d'impulsions successives à haute fréquence ($P_{ki}$, $P_{k'i}$) décalées dans le temps les unes par rapport aux autres par des pauses entre les impulsions à haute fréquence ($P_{ki}$, $P_{k'i}$), la durée des pauses dépend de la fréquence de Larmor des premiers moments de spin dans le champ magnétique (B), de telle sorte que, comme effet d'une évolution du second moment de spin à la fin de la séquence, un processus de bascule et, par conséquent, un transfert de polarisation du second moment de spin (16) vers les premiers moments de spin (10) se produisent.

2. Procédé selon la revendication 1, **caractérisé en ce que**
   un seul angle de basculement de 90° et/ou 180° est utilisé pour chaque impulsion à haute fréquence de la séquence (S).

3. Procédé selon l'une des revendications 1 à 2, **caractérisé en ce que** les impulsions à haute fréquence sont générées le long de deux axes d'impulsion orientés perpendiculairement l'un par rapport à l'autre.

4. Procédé selon l'une des revendications 1 à 3, **caractérisé en ce qu'**une impulsion à haute fréquence ($P_{ki}$, $P_{k'i}$) de la séquence (S) est une impulsion composite dans laquelle une pluralité d'impulsions individuelles à haute fréquence est alignée le long de différents axes d'impulsion sans pause d'impulsion intermédiaire, de sorte qu'un angle de basculement effectif est réalisé lorsque l'impulsion composite est appliquée.

5. Procédé selon l'une des revendications 1 à 4, **caractérisé en ce qu'**un moment de spin électronique d'un centre coloré (14) d'un échantillon solide (12) est utilisé comme second moment de spin (16).

6. Procédé selon l'une des revendications 1 à 5, **caractérisé en ce que** pendant la seséquence (S), une section de séquence (S$_2$) est générée dans laquelle quatre impulsions à haute fréquence, décalées l'une par rapport à l'autre au moyen de durées égales de pauses d'impulsion entre les impulsions à haute fréquence, chacune avec un angle de basculement de 90°, se succèdent.

7. Procédé selon l'une des revendications 1 à 6, **caractérisé en ce que,** pendant la seséquence (S), une section de séquence (S$_2$) est générée dans laquelle un certain nombre d'impulsions à haute fréquence décalées les unes par rapport aux autres au moyen de durées égales de pauses d'impulsion entre les impulsions à haute fréquence se succèdent avec un angle de basculement de 180° dans chaque cas, où les impulsions à haute fréquence sont alternativement formées comme des impulsions composites, dans lesquelles plusieurs impulsions individuelles à haute fréquence sont alignées le long de différents axes d'impulsion sans pause entre les impulsions, de sorte qu'un angle de basculement effectif est exécuté lorsque l'impulsion composite est appliquée.

8. Procédé selon l'une des revendications 1 à 7, **caractérisé en ce que** pendant la séquence (S), une première section de séquence (S$_3$) et une impulsion à haute fréquence avec un angle de basculement de 90° ainsi qu'une deuxième section de séquence (S4) sont générées successivement, pendant les sections de séquence (S$_3$, S$_4$), un certain nombre d'impulsions étant générées au moyen de durées égales (T) se succèdent avec un angle de basculement de 180° dans chaque cas, et les durées (T) de la deuxième section de séquence (S$_4$) ayant un décalage temporel relatif ($\Delta\tau$) par rapport aux durées (1) du premier segment de séquence (S$_3$).

9. Procédé selon l'une des revendications 1 à 8, **caractérisé en ce que** pendant la séquence (S), une première section de séquence (S$_5$) et une deuxième section de séquence (S$_6$) sont générées immédiatement l'une après l'autre, les sections de séquence (S$_5$, S$_6$) comprenant chacune deux impulsions à haute fréquence avec un angle de basculement de 90°, entre lesquelles, dans chaque cas, une impulsion à haute fréquence avec un angle de basculement de 180° est disposée de manière centrale, dans la première section de séquence (S$_5$), les impulsions à haute fréquence avec un angle de basculement de 90° étant générées le long d'un premier axe d'impulsion et l'impulsion à haute fréquence avec un angle de basculement de 180° est générée le long d'un deuxième axe d'impulsion orienté perpendiculairement au premier axe d'impulsion, et dans la deuxième section de séquence (S$_6$), les impulsions à haute fréquence avec un angle de basculement de 90° étant générées le long du deuxième axe d'impulsion et l'impulsion à haute fréquence avec un angle de basculement de 180° est générée le long du premier axe d'impulsion négatif.

10. Procédé selon l'une quelconque des revendications 8 ou 9, **caractérisé en ce que** la ou les sections de la séquence (S$_1$, S$_2$, S$_3$, S$_4$, S$_5$, S$_6$) sont répétées plusieurs fois de suite au cours de la séquence (S).

11. Dispositif (2) configuré pour hyperpolariser un échantillon de matériau (4) avant et/ou pendant une analyse par résonance magnétique selon le procédé de l'une quelconque des revendications 1 à 10.

**FIG. 1**

EP 3 563 143 B1

FIG. 2

EP 3 563 143 B1

$S, T$

$S_k, T_{kj}, E_{kj}$

$S_{k'}, T_{k'j}, E_{k'j}$

$\times N$

$\tau_{k1}$

$P_{k1}$  $P_{k2}$  $P_{kn_k}$

$\tau_{k'1}$

$P_{k'1}$  $P_{k'2}$  $P_{k'n_{k'}}$

$\bullet \bullet \bullet$

$\bullet \bullet \bullet$

$P_{init}$

$\tau^{pulse}_{k1}$  $\tau^{pulse}_{k2}$  $\tau^{pulse}_{kn_k}$

$P_{inter}$

$\tau^{pulse}_{k'1}$  $\tau^{pulse}_{k'2}$  $\tau^{pulse}_{k'n_{k'}}$

$P_{end}$

**FIG. 3**

$S, S_1$

$\tau/2$  $\tau/2$  $\tau/2$  $\tau/2$

$\times N$

$P^Y_{90°}$

$P^X_{90°}$  $P^X_{90°}$  $P^X_{90°}$  $P^X_{90°}$

$E_{11}$  $E_{12}$  $E_{13}$  $E_{14}$

**FIG. 4**

$S, S_2$

$3\tau/4$    $3\tau/4$    $3\tau/4$    $3\tau/4$    $3\tau/4$    $3\tau/4$    $3\tau/4$    $3\tau/4$

$\times N$

$P^Y_{90°}$

$P^X_{180°}$  $P^{Y-Z}_{180°}$  $P^X_{180°}$  $P^{Y-Z}_{180°}$  $P^X_{180°}$  $P^{Y-Z}_{180°}$  $P^X_{180°}$  $P^{Y-Z}_{180°}$

$E_{21}$       $E_{22}$       $E_{23}$       $E_{24}$

**FIG. 5**

$P^{Y-Z}_{180°}$

$P^X_{180°}$     $P^Y_{180°}$

$P^{1/\sqrt{2}(X+Y)}_{180°}$     $P^{1/\sqrt{2}(X+Y)}_{180°}$

**FIG. 6**

FIG. 7

FIG. 8

FIG. 9a

FIG. 9b

## IN DER BESCHREIBUNG AUFGEFÜHRTE DOKUMENTE

**In der Beschreibung aufgeführte Patentdokumente**

- US 20150064113 A1
- US 20160061914 A1
- US 20080231281 A1

**In der Beschreibung aufgeführte Nicht-Patentliteratur**

- **TAMINIAU, T. H.** Universal control and error correction in multi-qubits in registers in diamond. *Nature Nanotechnology,* 2014, vol. 9 (3), 171-176
- **NASIBULOV, E. A. et al.** Theory of the Overhauser effect in the pulsed mode of EPR pumping: exploiting the advantages of coherent electron spin motion. *Phyical Cchemistry Chemical Physics.,* 2012, vol. 14 (18), 6459
- **KORCHAK, S. E. et al.** Low-Field, Time-Resolved Dynamic Nuclear Polarization with Field Cycling and High-Resolution NMR Detection. *Applied Magnetic Resonance,* 2009, vol. 37 (1-4), 515
- **ALECCI, M. et al.** Low Field (10 mT) Pulsed Dynamic Nuclear Polarization. *Journal of Magnetic Resona,* 1999, vol. 138 (2), 313